(19)

(11) **EP 4 154 316 B1**

(12) **EUROPEAN PATENT SPECIFICATION**

(45) Date of publication and mention of the grant of the patent: **19.06.2024 Bulletin 2024/25**

(21) Application number: **21725226.1**

(22) Date of filing: **18.05.2021**

(51) International Patent Classification (IPC):
***H01L 27/15*** *(2006.01)* ***H01L 33/44*** *(2010.01)*
***H01L 33/50*** *(2010.01)* ***H01L 33/36*** *(2010.01)*
***H01L 33/42*** *(2010.01)* ***H01L 33/16*** *(2010.01)*
***G02B 1/116*** *(2015.01)* ***G02B 1/118*** *(2015.01)*

(52) Cooperative Patent Classification (CPC):
**H01L 27/156; H01L 33/36; H01L 33/44;** G02B 1/116; G02B 1/118; G02B 19/0066; H01L 33/16; H01L 33/42

(86) International application number: **PCT/EP2021/063144**

(87) International publication number: **WO 2021/233917 (25.11.2021 Gazette 2021/47)**

(54) **LIGHT EMITTING DEVICE ARRAY**

ANORDNUNG VON LICHTEMITTIERENDEN VORRICHTUNGEN

RÉSEAU DE DISPOSITIFS ÉMETTEURS DE LUMIÈRE

(84) Designated Contracting States:
**AL AT BE BG CH CY CZ DE DK EE ES FI FR GR HR HU IE IS IT LI LT LU LV MC MK MT NL NO PL PT RO RS SE SI SK SM TR**

(30) Priority: **22.05.2020 GB 202007719**

(43) Date of publication of application: **29.03.2023 Bulletin 2023/13**

(73) Proprietor: **Plessey Semiconductors Limited Plymouth, Devon PL6 7BQ (GB)**

(72) Inventors:
- **MEZOUARI, Samir Plymouth, Devon PL6 7BQ (GB)**
- **PINOS, Andrea Plymouth, Devon PL6 7BQ (GB)**

(74) Representative: **Boult Wade Tennant LLP Salisbury Square House 8 Salisbury Square London EC4Y 8AP (GB)**

(56) References cited:
**EP-A2- 2 757 598** **EP-A2- 3 624 198**
**WO-A1-2016/079505**

- **J.K. KIM ET AL: "Light-Extraction Enhancement of GaInN Light-Emitting Diodes by Graded-Refractive-Index Indium Tin Oxide Anti-Reflection Contact", ADVANCED MATERIALS, vol. 20, no. 4, 18 February 2008 (2008-02-18), pages 801-804, XP055289758, ISSN: 0935-9648, DOI: 10.1002/adma.200701015 cited in the application**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 154 316 B1

## Description

### Field of the disclosure

The present disclosure relates to arrays comprising light emitting devices. In particular, the present disclosure relates to light emitting device arrays comprising Group III-nitrides.

### Background

Micro light emitting device arrays are commonly defined as arrays of light emitting devices, such as Light Emitting Diodes (LEDs), with a size of $100 \times 100\ \mu m^2$ or less. Micro LED arrays are self-emitting micro-displays/projectors which may be suitable for use in a variety of devices such as smartwatches, head-wearing displays, head-up displays, camcorders, viewfinders, multisite excitation sources, and pico-projectors.

One known form of a micro LED array comprises a plurality of LEDs formed from Group III-nitrides. Group III-nitride LEDs are inorganic semiconductor LEDs containing GaN and its alloys with InN and AlN in the active light-emitting region. Group III-nitride LEDs can be driven at significantly higher current density and emit a higher optical power density than conventional large-area LEDs, for example organic light emitting diodes (OLED) in which the light-emitting layer is an organic compound. As a result, higher luminance (brightness), defined as the amount of light emitted per unit area of the light source in a given direction, makes micro LEDs suitable for applications requiring or benefiting from, high brightness. For example, applications that benefit from high brightness may include displays in high brightness environments or projectors. Additionally, Group III-nitride micro LEDs are known to have relatively high luminous efficacy, expressed in lumens per watt (lm/W) compared to other conventional large area LEDs. The relatively high luminous efficacy of Group III-nitride micro LED arrays reduces power usage compared with other light sources and makes micro LEDs particularly suitable for portable devices.

A micro-LED is disclosed in US 2016365383. The micro-LED includes a parabolic mesa structure including an active layer which is configured to generate light. The surface of the mesa structure acts as a reflector such that a greater portion of the generated light is directed to an opposing exit surface at an incident angle less than the critical angle to the normal.

It is an object of the present invention to provide an improved light emitting device array which tackles at least one of the problems associated with prior art light emitting device arrays or, at least, provide a commercially useful alternative thereto.

EP-A-3624198 discloses a display device which includes a substrate, an emissive layer, a plurality of colour converting layers that share the emissive layer, and an insulating layer provided between the emissive layer and the plurality of colour converting layers and having a smaller refractive index than the emissive layer.

### Summary

The present inventors have realised that introducing a mesa structure into a light emitting device reduces the size of the active layer in which light is generated. Moreover, patterning and forming individual mesa structures for an array of light emitting devices requires the array to undergo a number of processing steps which must be carefully aligned.

According to a first aspect of the disclosure, a light emitting device array is provided. The light emitting device array comprises a light emitting stack, a first electrical contact layer, an array of second electrical contacts, and an anti-reflection layer. The light emitting stack has a light emitting surface and a contact surface. The light emitting surface and the contact surface define opposing sides of the light emitting stack. The light emitting stack comprises a plurality of Group III-nitride layers including a first semiconducting layer provided towards the light emitting surface of the light emitting stack, a second semiconducting layer provided towards the contact surface, and an active layer arranged between the first semiconducting layer and the second semiconducting layer, the active layer configured to generate light having a first wavelength. The light emitting surface and the contact surface are parallel to each other and aligned with the plurality of Group III-nitride layers. The first electrical contact layer is provided on the light emitting stack and is configured to be in electrical contact with the first semiconducting layer. The array of second electrical contacts is provided on the contact surface of the light emitting stack. Each second electrical contact defines a light emitting device between the first semiconducting layer and the second electrical contact. Each of the second electrical contacts is spaced apart from the other second electrical contacts to form a two-dimensional array of light emitting devices. The anti-reflection layer is provided on the light emitting surface. The anti-reflection layer is configured to increase a light extraction efficiency of the light generated by the light emitting stack.

The light emitting device array of the first aspect has a light emitting device layer including an active layer. Individual light emitting devices are defined by the array of second electrical contacts on the contact surface. Regions of the active layer aligned with an individual second electrical contact can be turned on by the respective second electrical contact in order to emit light. The first electrical contact layer effectively forms a common first electrical contact for each of the light emitting devices.

Light generated by the active layer is emitted in all directions within the light emitting stack. As the light emitting surface and the contact surface of the light emitting stack are parallel, light which is incident on the light emitting surface (or the contact surface) at an angle greater than the critical angle is totally internally reflected within the light emitting stack. As such, only light which is incident on the light emitting surface at an angle less than the critical angle is emitted from the device. Accordingly, only light within a narrow range of angles is transmitted through the light emitting surface for each light emitting device. Accordingly, an array of light emitting devices may be provided using a (generally planar) light emitting stack which does not require multiple alignment steps in order to form light extraction features, such as a mesa structure.

The interface at the light emitting surface is subject to reflection of light, even for light with an angle of incidence less than the critical angle. In order to extract light from the light emitting surface, an anti-reflection layer is provided. The anti-reflection layer increases the light extraction efficiency of the light emitting surface.

Increasing the light extraction efficiency of the light emitting surface is important due to the refraction of light occurring at the light emitting surface. That is to say, light with an angle of incidence less than the critical angle is also refracted as it is transmitted from the light emitting stack to the air. As the refractive index of Group III-nitrides are generally higher than the refractive index of air, refraction acts to reduce the appearance of cross talk between light emitting devices of the light emitting device array.

In some embodiments, the light emitting device array comprises an absorbing layer configured to absorb light of the first wavelength generated by the active layer; the absorbing layer provided on at least a portion of the light emitting stack. The absorbing layer is configured to absorb stray light generated by the active layer in order to improve the optical properties of the light emitting device array. The absorbing layer may be provided on various regions of the light emitting stack.

For example, the absorbing layer may be provided on at least one sidewall surface of the light emitting stack extending between the light emitting surface and the contact surface. Accordingly, the absorbing layer may be arranged to absorb light which has been totally internally reflected between the light emitting surface and the contact surface once it reaches the sidewall surface of the light emitting stack. In some embodiments, the absorbing layer may be provided on all sidewall surfaces of the light emitting stack.

In some embodiments, the absorbing layer may be provided on the light emitting surface. For example, in some embodiments, the absorbing layer may be provided around a perimeter of the light emitting surface. In some embodiments, the absorbing layer may be provided across the light emitting surface, wherein the absorbing layer comprises a plurality of comprises opening on the light emitting surface, each opening aligned with a second electrical contact such that light from each light emitting device is transmitted through a respective opening. As such, the absorbing layer may be provided on the light emitting surface in regions between each light emitting device in order to reduce cross talk between adjacent light emitting devices.

In some embodiments, the absorbing layer is provided on the contact surface, wherein the absorbing layer is provided in regions of the contact surface between adjacent second electrical contacts of the array of second electrical contacts. By providing the absorbing layer on the contact surface, light which is emitted from the active layer towards the contact surface may be absorbed by the absorbing layer, rather than potentially being reflected back towards the light emitting surface. Thus, the absorbing layer may reduce the cross talk between adjacent light emitting devices.

In some embodiments, first electrical contact layer is provided on the light emitting surface. In some embodiments, the anti-reflection layer is provided between the first contact electrical layer and the light emitting surface. For example, the anti-reflection layer may comprise a porous semiconducting layer, while the common first contact layer comprises a transparent conductive oxide, for example Indium Tin Oxide (ITO).

In some embodiments, the first electrical contact layer is provided between the light emitting surface and the anti-reflection layer. The anti-reflection layer may comprise $SiO_2$, while the first electrical contact layer comprises a transparent conductive oxide, for example Indium Tin Oxide (ITO).

In some embodiments, the anti-reflection layer comprises a porous semiconducting layer having an areal porosity of at least 30%. For example, the porous semiconducting layer may comprise a Group III-nitride layer. In some embodiments, the porous semiconducting layer may be formed from a Group-III nitride semiconducting layer which has been subjected to a porosity treatment process. For example, in some embodiments, the porous semiconducting layer may be formed from a third semiconducting layer comprising a n-type doped Group III-nitride. Increasing the areal porosity of the Group III-nitride semiconducting layer may change the refractive index of the Group III-nitride semiconducting layer (relative to the refractive index of the as-formed layer), such that the porous semiconducting layer may be suitable for use as an antireflection layer. Of course, it will be appreciated that areal porosity is only one possible method for assessing the porosity of the porous semiconducting layer. Other methods of characterising porosity, for example volumetric porosity may also provide a porous semiconducting layer which is suitable for use as an antireflection layer.

In some embodiments, a pitch of each second electrical contact in the light emitting device array is no greater

than 5 μm, or 2 μm. As such, the centres of adjacent second electrical contacts are spaced apart by no greater than 5 μm, or 2 μm. It will be appreciated that as the pitch of the array is reduced, the size of the active area for each light emitting device is also reduced. For devices with a pitch of no greater than 5 μm, or 2 μm, it is important to utilise as much active area as possible in order to increase the amount of light generated by each light emitting device.

In some embodiments, the first electrical contact layer comprises a transparent conductive oxide provided on the light emitting surface. The first electrical contact may be substantially transparent to the first wavelength of light generated by the active layer. The first electrical contact layer may be provided across the light emitting surface as a substantially continuous layer. Accordingly, the light emitting device array may be provided with a common first electrical contact using a process which does not require its own alignment step, or any patterning. Thus, the light emitting device array may be formed as a device comprising a plurality of self-aligned, substantially continuous layers, and the array of second electrical contacts.

In some embodiments the first electrical contact layer may be formed using other methods for forming electrical contacts to a semiconducting layer. For example, in some embodiments the light emitting stack further comprises a via semiconducting portion provided in the light emitting stack extending through the active layer between the first semiconducting layer and the contact surface. The first electrical contact layer is provided on contact surface in electrical contact with the via semiconducting portion. In some embodiments, the first electrical contact layer may be provided as a perimeter first electrical contact. The perimeter first electrical contact may be configured to surround all of the second electrical contacts. The perimeter first electrical contact maybe provided on the contact surface of the light emitting stack, aligned with a corresponding via semiconducting portion.

In some embodiments, the first electrical contact layer may be provided as a perimeter first electrical contact which is provided on the light emitting surface. Effectively, the perimeter electrical contact may define an opening on the light emitting surface, wherein the opening is aligned with the array of second electrical contacts 30. As such, a perimeter electrical contact arrangement may provide an alternative to a forming the first electrical contact layer from a transparent oxide. The formation of a perimeter electrical contact may involve a further alignment and patterning step.

In some embodiments, the first electrical contact layer and the anti-reflection layer may be formed on the light emitting surface to form a graded refractive index interface between the light emitting surface of the light emitting stack and the surroundings. As such, the anti-reflection layer and the first electrical contact layer may be configured to form a graded refractive index (GRIN) structure having both anti-reflection and electrical contact functionality. The GRIN structure may comprises a plurality of layers wherein at least one of the plurality of layers provides the first electrical contact layer, whilst at least one other layer provides the anti-reflection layer. The plurality of layers are formed in order to provide a graded refractive index between the light emitting surface and the surroundings in order to reduce reflection at the interface. In some embodiments, the GRIN structure including the first electrical contact layer and the anti-reflection layer may be comprise substantially the same material, for example a transparent conductive oxide.

The light emitting stack comprises a plurality of Group III-nitride layers. In some embodiments, the light emitting stack is formed from a plurality of generally planar Group III-nitride layers. The light emitting stack may be formed from a plurality of Group III-nitride layers with, when assembled as a light emitting stack are configured to generate light in response to the application of an electrical current. For example, in some embodiments, the light emitting stack comprises a first semiconducting layer, a second semiconducting layer and an active layer.

In some embodiments, the first semiconducting layer comprises a n-type doped Group III-nitride. In some embodiments, the second semiconducting layer comprises a p-type doped Group III-nitride. In some embodiments, the active layer comprises multiple quantum well layers comprising Group III-nitrides.

In some embodiments, the active layer extends as a continuous layer between at least two adjacent light emitting devices of the light emitting device array. As such, the active layer may be provided light emitting devices of the array without any patterning of the active layer. That is to say, the active layer for each light emitting device does not utilise a mesa structure or other patterning to provide an array of light emitting devices. Rather, the light emitting stack emits light based on the arrangement of the array of second electrical contacts.

According to a second aspect of the disclosure, a method of forming a light emitting device array is provided. The method comprises:

forming a light emitting stack on a substrate surface of a substrate, the light emitting stack having a light emitting surface in contact with the substrate surface and a contact surface on an opposing side of the light emitting stack, forming the light emitting stack comprising forming a plurality of Group III-nitride layers including:

a first semiconducting layer provided towards the substrate surface;
a second semiconducting layer provided towards a contact surface of the light emitting stack; and
an active layer provided between the first semiconducting layer and the second semiconducting layer, the active layer configured to generate light having a first wavelength;

wherein the light emitting surface and the contact surface of the light emitting stack are formed parallel to each other and aligned with the plurality of Group III-nitride layers;
forming an array of second electrical contacts on the contact surface of the light emitting stack, each second electrical contact defining a light emitting device between the first semiconducting layer and the second electrical contact, wherein each of the second electrical contacts are spaced apart from the other second electrical contacts to form a two-dimensional array of the light emitting devices;
removing the substrate from the light emitting stack to expose the light emitting surface of the light emitting stack;
forming a first electrical contact layer on the light emitting stack, the first electrical contact layer configured to be in electrical contact with the first semiconducting layer; and
forming an anti-reflection layer on the light emitting surface, the anti-reflection layer configured to increase a light extraction efficiency of light generated by the light emitting stack.

Accordingly, the method of the second aspect of the disclosure may provide a light emitting device array according to the first aspect of the disclosure. As such, the method of the second aspect of the disclosure may incorporate steps of forming the optional features, and the associated advantages, as discussed above for the first aspect of the disclosure.

The method according to the second aspect of the disclosure includes the formation of the light emitting stack on a substrate. As such, the light emitting stack may be formed monolithically on a substrate, prior to removal of the substrate. The monolithic formation of the light emitting stack is a self-aligned process. That is to say, the light emitting stack may be formed without any patterning steps, which reduces the complexity of the device and also reduces the alignment tolerances that may be included between devices. Reducing alignment tolerances may be particularly beneficial for small pitch devices, as the size of the active area relative to the device pitch may be increased.

In some embodiments, forming the anti-reflection layer comprises forming a third semiconducting layer comprising a Group III-nitride and a donor density of at least $1 \times 10^{18}$ $cm^{-3}$ on the light emitting surface, subjecting the third semiconducting layer to a porosity treatment process to increase an areal porosity of the third semiconducting layer to at least 30%. By forming the anti-reflection layer from a Group-III nitride, the anti-reflection layer may be deposited as the third semiconducting layer as part of the process of forming the light emitting stack on the substrate. That is to say, the third semiconducting layer may be formed monolithically with the light emitting stack.

## Brief description of the Figures

- Figure 1 shows a cross-sectional diagram of a light emitting device array according to an embodiment of the disclosure;
- Figure 2 shows an annotated cross-sectional diagram of the light emitting device array shown in Figure 1;
- Figure 3 shows a graph of the absorptance of 50 nm of titanium on GaN;

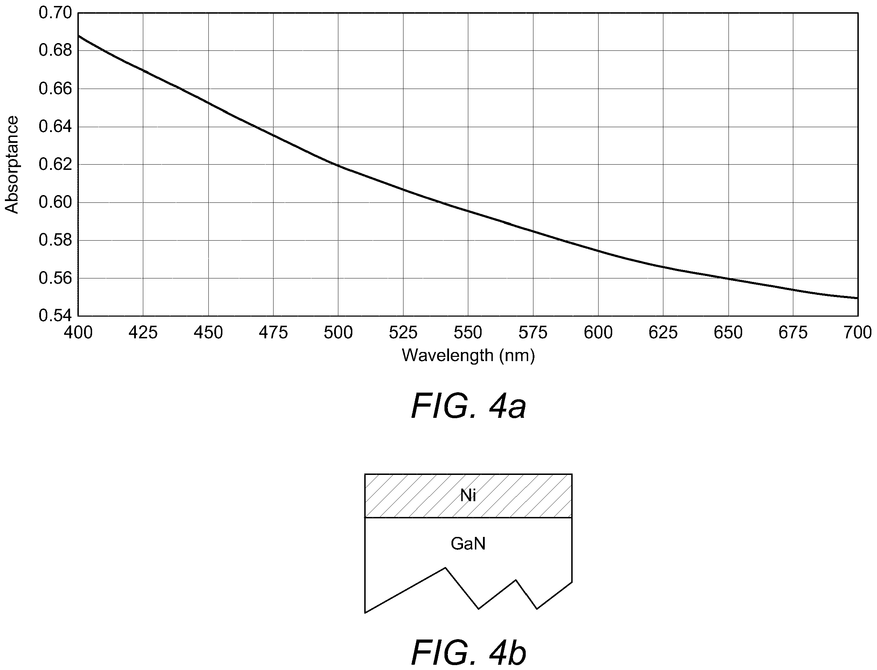

- Figure 4 shows a graph of the absorptance of 50 nm of nickel on GaN;
- Figure 5a shows a diagram of a light emitting stack without an anti-reflection layer;
- Figure 5b shows a graph of the reflectance at the light emitting interface between the light emitting stack and air for different angles of incidence;
- Figure 6a shows a diagram of a light emitting stack and an anti-reflection layer;
- Figure 6b shows a graph of the reflectance of the light emitting stack and anti-reflection layer of 6a at different angles of incidence;
- Figure 7 shows a diagram of a light emitting stack with two layers formed on the light emitting surface;
- Figure 8 shows a diagram of a light emitting stack with an anti-reflection layer and a transparent conductive oxide common contact layer;
- Figure 9 shows a graph of the reflectance of the structure shown in Figure 8;
- Figure 10 shows a diagram of a light emitting stack with a $SiO_2$ anti-reflection layer and a transparent conductive oxide common contact layer;
- Figure 11 shows a graph of the reflectance of the structure shown in Figure 10;
- Figure 12 shows a diagram of a light emitting stack with an anti-reflection layer comprising a plurality of sublayers and a transparent conductive oxide common contact layer;
- Figure 13 shows a graph of the reflectance of the structure shown in Figure 12;
- Figure 14 shows a diagram of a light emitting stack with an anti-reflection layer and a transparent conductive oxide common contact layer arranged to provide a graded refractive index interface;
- Figure 15 shows a cross-sectional diagram of a light emitting device array according to a second embodiment of the disclosure;

- Figure 16 shows a cross-sectional diagram of a light emitting device array according to a third embodiment of the disclosure;
- Figures 17a, 17b, 17c, 17d, and 17e show cross-sectional diagrams of a process flow for forming a light emitting device array according to a fourth embodiment of the disclosure;
- Figure 18 shows a plan view of a contact surface of a light emitting device array.

**Detailed Description**

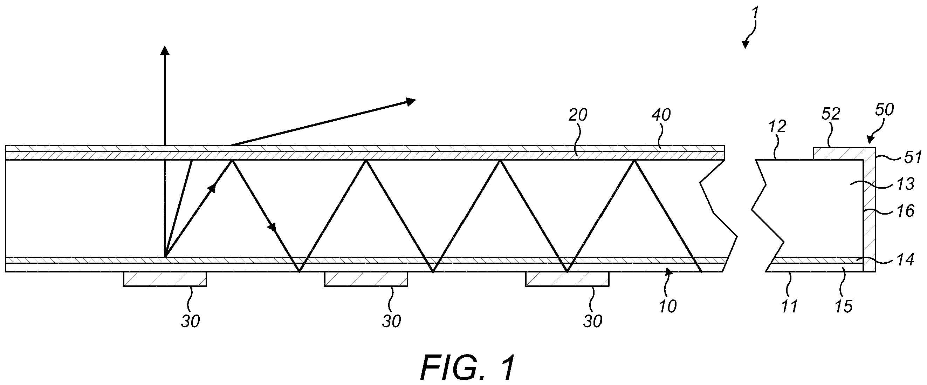

According to a first embodiment of the disclosure, a light emitting device array 1 is provided. The light emitting device array 1 comprises a light emitting stack 10, a common first contact layer 40, an array of second electrical contacts 30, an anti-reflection layer 20, and an absorbing layer 50. A cross-section of the light emitting device array 1 according to the first embodiment is shown in Fig. 1.

As shown in Fig. 1, the light emitting stack 10 has a contact surface 11 and a light emitting surface 12. The light emitting surface 12 and the contact surface 11 are (opposing) major surfaces of the light emitting stack 10. The light emitting stack 10 also includes sidewall surfaces 16 which extend from the contact surface 11 to the light emitting surface 12. The cross-section shown in Fig. 1 shows a portion of the light emitting device array 1 in a central region of the light emitting device array and a portion of the light emitting device array towards one of the sidewall surfaces 16. The light emitting surface 12 and the contact surface 11 of the light emitting stack 10 are parallel to each other. As such, the light emitting surface 12 and the contact surface 11 are substantially continuous surfaces which extend in planes parallel to each other. The parallel nature of the light emitting surface 12 and the contact surface 11 allows for light generated within the light emitting stack 10 to be totally internally reflected between the light emitting surface 12 and the contact surface 11 if the angle of incidence of the light on either the light emitting surface 12 or the contact surface 11 is greater than the critical angle.

The light emitting stack 10 comprises a plurality of Group III-nitride layers. The plurality of Group-III nitride layers are configured to provide a light emitting region within the light emitting stack 10. As shown in Fig. 1, the light emitting stack 10 comprises a first semiconducting layer 13, an active layer 14, and a second semiconducting layer 15. The active layer 14 is arranged between the first semiconducting layer 13 and the second semiconducting layer 15. As shown in the embodiment of Fig. 1, the first semiconducting layer 13, the active layer 14, and the second semiconducting layer 15 are all substantially continuous layers which are formed on top of each other. As such, the layers of the light emitting stack are generally co-planar.

In the embodiment of Fig. 1, the first semiconducting layer 13 comprises a Group III-nitride. In some embodiments, the first semiconducting layer 13 comprises GaN. In some embodiments, the first semiconducting layer 13 comprises a Group III-nitride which is doped with an n-type dopant. For example, the first semiconducting layer 13 may comprise n-type doped GaN. Any suitable n-type dopant may be used to dope the first semiconducting layer n-type, for example Si, or Ge.

The active layer 14 is configured to generate light having a first wavelength. As such, the active layer 14 is configured to provide a light generating region of the light emitting stack 10. In some embodiments, the active layer may comprise a plurality of quantum well layers. Accordingly, the active layer 14 may be configured to generate light of the first wavelength which is a wavelength of at least 400 nm. In some embodiments, the light of the first wavelength may have a wavelength of no greater than 650 nm, or no greater than 500 nm. As such, the active layer 14 of the first embodiment may be configured to generate substantially visible light.

The active layer 14 may comprise one or more quantum wells for the generation of photons. The quantum wells may be formed from a plurality of layers of Group III-nitrides with different bandgaps. In some embodiments, a Group III-nitride alloy including In may be used to form a quantum well. Multiple quantum well active layers for LEDs comprising Group-III nitrides are known to the skilled person. In some embodiments, an active layer 14 comprising alternating layers of GaN and InGaN may be provided.

The second semiconducting layer 15 may be p-type doped. As such, the second semiconducting layer 15 may comprise a p-type dopant, for example, Mg. For example, in the embodiment of Fig. 1, the second semiconducting layer comprises GaN which is p-type doped with Mg.

The first semiconducting layer 13, the active layer 14, and the second semiconducting layer 15 may be formed by any suitable process for the formation of Group III-nitrides. For example, in some embodiments the layers of the light emitting stack 10 may be formed using a metal organo chemical vapour deposition (MOCVD) process, a molecular beam epitaxy (MBE) process, or any other suitable method. In some embodiments, for example the embodiment of Fig. 1, the layers of the light emitting stack 1 may be formed in a single deposition process as a monolithic structure. The layers of the light emitting stack 10 may be formed on a substrate (not shown). The light emitting device stack 10 may be formed on a substrate with the first semiconducting layer 13 formed first followed afterwards by the formation of the active layer 14 and subsequently the second semiconducting layer 15. Other electronics layers may also be included in the light emitting device stack (not shown). For example, an electron blocking layer or a third semiconducting layer (discussed below) may also be formed as part of the process for forming the light emitting stack 10.

As shown in Fig. 1, an anti-reflection layer 20 is formed on the light emitting surface 12 of the light emitting stack 10. The anti-reflection layer 20 is configured to reduce reflection of the light of the first wavelength at the interface between the light emitting device array and the surrounding air at the light emitting surface 12. The anti-reflection layer 20 may be provided using any suitable anti-reflection layer known to the skilled person. For example, in the embodiment of Fig. 1, the anti-reflection layer 20 comprises a material having a refractive index of no greater than the refractive index the second semiconducting layer 15 and more than the refractive index of air. The anti-reflection also has a thickness in a direction normal to the light emitting surface 12 of around one quarter of the thickness of the first wavelength.

In the embodiment of Fig. 1, the antireflection layer 20 comprises a porous semiconducting layer. The porous semiconducting layer is discussed in more detail below. The anti-reflection layer 20 is provided at the light emitting surface 12 in order to increase the light extraction efficiency of light which is incident on the light emitting surface 12 at an angle of incidence which is less than the critical angle ($\theta_c$).

As shown in Fig. 1 the light emitting device array 1 comprises an array of second electrical contacts 30. The array of second electrical contacts 30 are provided on the contact surface 11 of the light emitting stack 10. Each second electrical contact 30 defines a light emitting device between the first semiconducting layer 13 and the respective second electrical contact 30. As shown in Fig. 1, the second electrical contacts 30 are spaced apart from each other in order to form an array of second electrical contacts 30. Consequently, as each second electrical contact 30 defines a light emitting device, the array of second electrical contacts 30 defines the arrangement of the light emitting devices in the light emitting device array. Each second electrical contact 30 allows the respective light emitting device to be controlled independently of the other light emitting devices. Application of a voltage to the second electrical contacts provides a localised electrical field between the third electrical contact and the first semiconducting layer 13 which causes the active layer 14 to generate light.

The generation of light in the active layer 14 is localised in regions of the active layer which overlap with the second electrical contacts 30. As such, the active layer 14 comprises a plurality of light generating regions. Each light generating region is aligned with a respective second electrical contact. Each light generating region is generally of a similar cross sectional area in a plane parallel to the light emitting surface 12 as the respective second electrical contact 30.

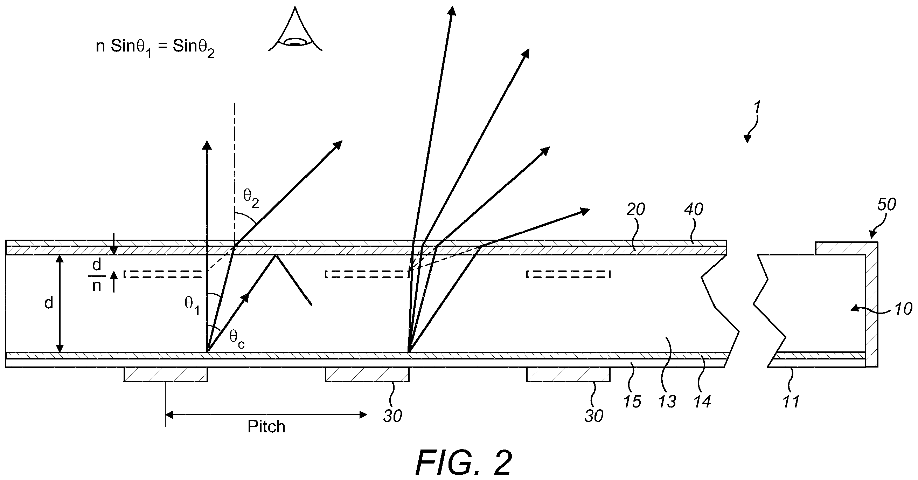

Each light generating region of the active layer 14 generates light which is emitted in all directions. A portion of the light generated by each light generating region will be transmitted in a direction normal to the active layer 14 towards the light emitting surface 12. As shown in Fig. 2, light which is incident on the light emitting surface 12 at an angle to the normal of less than the critical angle ($\theta_1 < \theta_c$) will be at least partially transmitted through the light emitting surface 12. For example, light generated by the active layer 14 in a direction normal to the active layer 14 will be generally transmitted through the light emitting surface 12. Light which is incident on the light emitting surface 12 at an angle greater than or equal to the critical angle $\theta_C$ will be totally internally reflected within the light emitting stack 10. As such, light which is incident on the light emitting surface 12 at an angle to the normal of at least the critical angle will not be transmitted through the light emitting surface 12. Accordingly, total internal reflection and the critical angle are used in the light emitting device array 1 to restrict the light emitted from the light emitting device to a subset of angles of emission.

The second electrical contacts 30 may comprise any suitable material for forming an Ohmic contact to the second semiconducting layer 15. For example, in some embodiments the second electrical contacts 30 may comprise one or more metal layers, for example gold, nickel, or titanium. The second electrical contacts 30 may be arranged on the contact surface 11 as a two-dimensional array. In some embodiments, the second electrical contacts 30 may be arranged as a square-packed array, or as a hexagonally-packed array. In the first embodiment, the second electrical contacts 30 are regularly spaced apart from each other in order to define an array of light emitting devices. The second electrical contacts 30 are spaced apart from each other in order to allow the individual light emitting devices to be controlled independently from each other.

In embodiments of this disclosure, the second electrical contacts 30 are spaced apart from each in order to provide an array of light emitting devices having a pitch. The pitch of the light emitting device array 1 in this disclosure refers to the centre-to-centre spacing of adjacent second electrical contacts 30. Moreover, the pitch refers to the smallest value for the centre-to-centre spacing between adjacent second electrical contacts in the array of second electrical contacts 30. That is to say, for example in a square-packed array, the pitch refers to the centre-to-centre spacing between adjacent second electrical contacts in the rows and/or columns, rather than along a diagonal direction. In some embodiments, a pitch of each second electrical contact in the light emitting device array may be no greater than 5 $\mu$m, or no greater than 2 $\mu$m. Accordingly, the pitches of each second electrical contact may define an array of micro light emitting devices wherein the pitch of each microlight emitting device is no greater than 5 $\mu$m or 2 $\mu$m.

For a given light emitting device pitch, a first portion of the light emitting device pitch may be taken up by the second electrical contacts 30. A second portion of the light emitting device pitch may be dedicated to the spacing between adjacent second electrical contacts 30. In some embodiments, the spacing to be provided between adjacent second electrical contacts may be at least 500 nm. The amount of spacing provided between adjacent second electrical contacts 30 may not significantly vary as the size of the light emitting device pitch is increased. Thus, as the device size increases, the fraction of the light emitting device pitch which is used for device spacing, rather than the second electrical contact may decrease.

As shown in Fig. 1, a common first contact layer 40 is provided on the light emitting surface 12. In the embodiment of Fig. 1, the common first contact layer 40 is provided covering the light emitting surface 12 of the light emitting stack 10 and the anti-reflection layer 20. As such, the anti-reflection layer 20 is provided between the light emitting stack 10 and the common first contact layer 40. In some embodiments, the anti-reflection layer 20 and the common first contact layer may be provided in the opposite arrangement (i.e. the common first contact layer 40 provided between the light emitting stack 10 and the anti-reflection layer 20).

In the embodiment of Fig. 1, the common first contact layer 40 comprises a transparent conductive oxide. The transparent conductive oxide is configured to be generally transparent to the first wavelength, and also to form an Ohmic contact to the first semiconducting layer 13 via the anti-reflection layer 20. For example, in some embodiments, the transparent conductive oxide may have a transmittance of at least 90 % for light of the first wavelength.

As shown in Fig. 1, the common first contact layer 40 is provided as a substantially continuous layer across the light emitting surface 12. The common first contact layer 40 provides a first contact for each of the light emitting devices of the light emitting device array 1. As such, the light emitting device array 1 of the first embodiment efficiently provides a common first contact layer for the devices of the light emitting device array in a self-aligned processing step.

As shown in Fig. 2, as light from the active layer travels from the light emitting stack through the light emitting surface 12 to the surrounding environment, the light is refracted. The refraction of light at the causes the angle of emission to the normal ($\theta_2$ in Fig. 2) to increase as it is output from the device. Such refraction further reduces the appearance of cross-talk between adjacent light emitting devices. A person observing the light emitting device array 1 (e.g. as indicated in Fig. 2) receives light from each light emitting device in a relatively narrow viewing angle. Light which is generated at angles of incidence approaching the critical angle is refracted such that a viewer may not observe this light. As such, the appearance of cross-talk between light emitting devices is reduced or eliminated.

The light emitting device array 1 of the first embodiment also comprises an absorbing layer 50. The absorbing layer 50 is configured to absorb light of the first wavelength generated by the active layer 14. The absorbing layer 50 may be provided on the light emitting stack 10 to cover regions of the light emitting stack where emission of the light of the first wavelength is undesirable. The absorbing layer 50 also to provide a means for absorbing light within the light emitting stack 10 which is totally internally reflected.

In the embodiment of Fig. 1, the absorbing layer 50 is provided on at least one of the sidewall surfaces 16 of the light emitting stack 10. The absorbing layer 50 may be provided as a substantially continuous layer on the sidewall surface 16. As shown in Fig. 1, a first portion of the absorbing layer 51 covers substantially the entire sidewall surface 16 of the light emitting stack 10.

The absorbing layer 50 may also be provided on other surfaces of the light emitting stack 10, for example around the perimeter of the light emitting surface 12. As shown in Fig. 1, a second portion of the absorbing layer 52 is provided around a perimeter of the light emitting surface 12 in order to define an edge region of the light emitting surface 12. The second portion of the absorbing layer 52 provided on the perimeter of the light emitting surface 12 may help reduce to eliminate unwanted optical effects due to the presence of the sidewall surfaces of the light emitting stack 10.

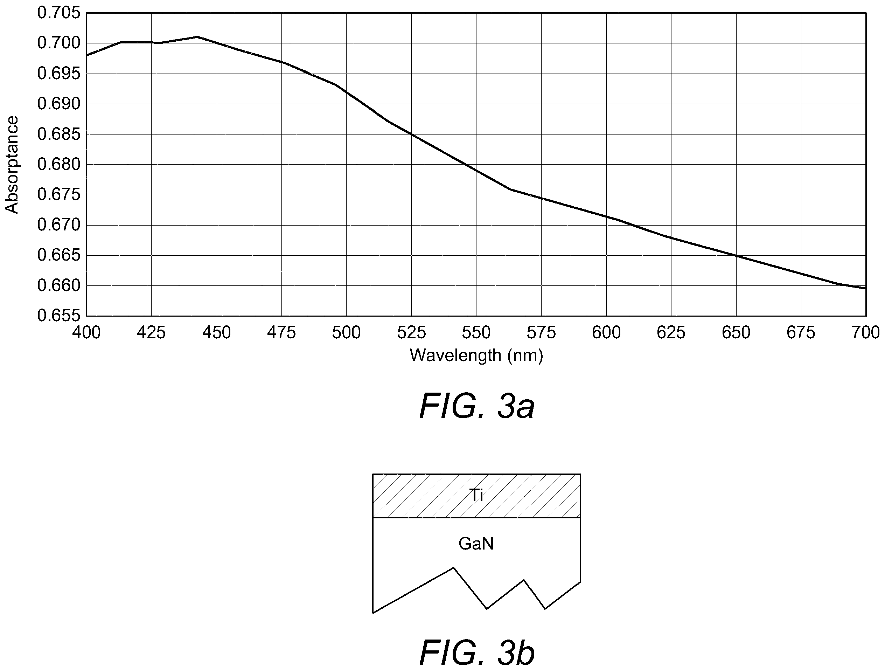

The absorbing layer 50 may comprise any suitable material configured to absorb light of the first wavelength. In the embodiment of Fig. 1 where the active layer 14 is configured to emit light having a first wavelength of between 440 nm and 500 nm, the absorbing layer 50 may comprise a layer of a metal such as Ni or Ti. Fig. 3a shows an absorptance plot for an absorbing layer comprising a 50 nm layer of Ti on a GaN substrate (a diagram of which is shown in Fig. 3b). Fig. 3 shows absorptance graph for a 50 nm layer of Ni on a GaN substrate. As such, it will be appreciated that metallic thin films (e.g. having a thickness of less than 500 nm) may be used to provide a suitable absorbing layer.

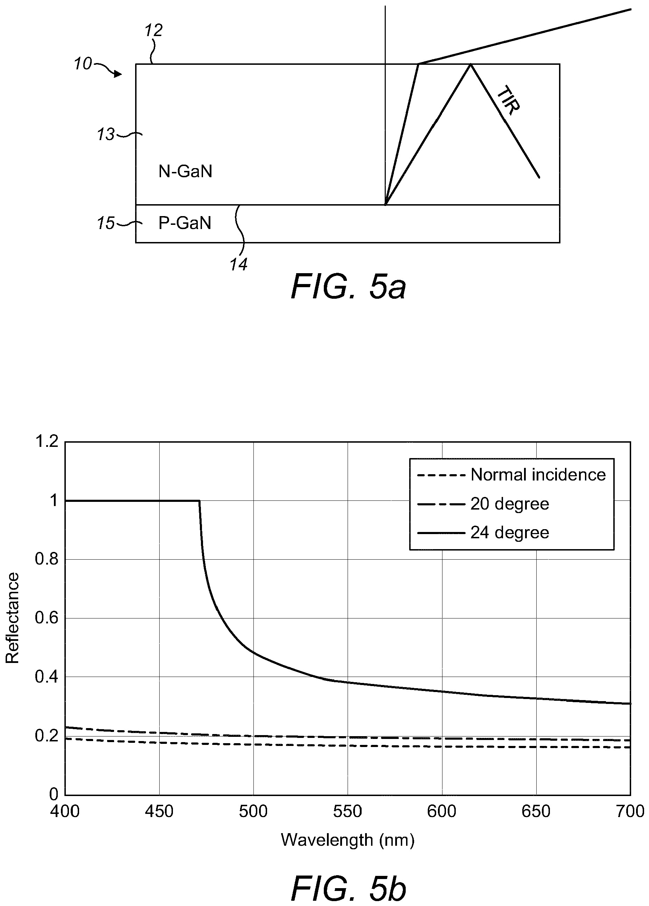

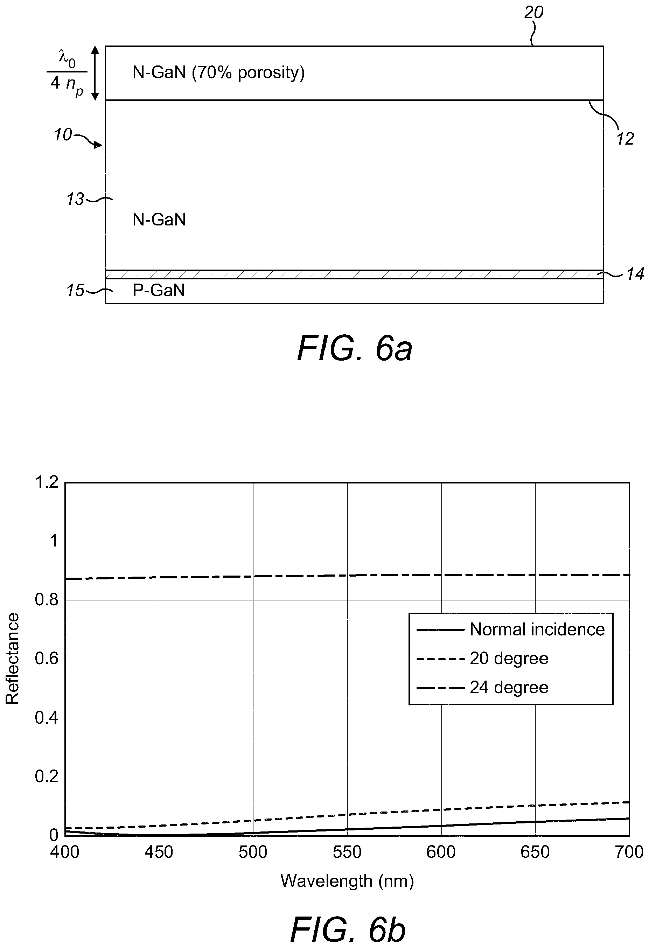

As discussed above, the anti-reflection layer 20 may comprise a porous semiconducting layer. The porous semiconducting layer will now be discussed with reference to Figs. 5a, 5b, 6a and 6b.

Fig. 5a shows a schematic diagram of a light emitting stack 10 without an anti-reflection layer provided on the light emitting surface 12. As such, the light emitting surface 12 is an interface between the first semiconducting layer 13, which comprises n-type doped GaN, and air. As shown in Fig. 5a, light, which is incident on the light emitting surface 12 from the active layer 14, is either partially transmitted through the light emitting surface 12 if the angle of incidence is less than the critical angle (i.e. some of the light may be reflected), or totally internally reflected if the angle of the incidence is greater than the critical angle.

Fig. 5b shows a plot of the reflectance for light of different wavelengths at the interface between the first semiconducting layer 13 and air. Fig. 5b shows the reflectance for light which is incident on the light emitting surface at an angle a) normal to the light emitting surface 12, b) incident at 20 degrees to the normal, and c) incident at 24 degrees to the normal. It will be appreciated from Fig. 5b, that the interface between the light emitting stack 10 and air may be highly reflective for light which is normally incident to the light emitting surface or angles close to the normal incidents. The reflectance for light having a wavelength of around 450 nm increases from just below 0.2 to 1.0 as the angle of incidence approaches the critical angle. For n-type doped GaN, the critical angle is around 24 degrees. Angles of incidence above 24 degrees will result in total internal reflection of the light.

Fig. 6a shows a schematic diagram for a light emitting stack 10 with an anti-reflection layer 20 provided on the light emitting surface 12. The anti-reflection layer 20 comprises n-type doped GaN which has been subjected to a porosity treatment process in order to increase the areal porosity of the GaN to at least 30%. The porosity treatment process is discussed in more detail below. In the schematic diagram of Fig. 6a, the areal porosity of the GaN is around 70%.

Fig. 6b shows a graph of the reflectance between the light emitting stack and air for the structure of Fig. 6a including the porous semiconducting layer. As shown in Fig. 6b, for light which is incident at the light emitting surface 12 in a direction generally normal to the light emitting surface 12 the reflectance for all wavelengths within the range 400nm to 700nm is less than 0.1. As the angle of incidence increases to 20 degrees, the reflectance remains less than 0.1. Thus, the anti-reflection layer 20 may be used to significantly reduce the reflection of light at angles of incidence which will be emitted from the light emitting device array at an emission angle suitable for observation by a viewer. As shown in Fig. 6b as the angle of incidence is increased to 24 degrees, the reflectance at the interface increases significantly to above 0.8. Of course, it will be appreciated from the information accompanying Fig. 2 that wider angles of incidence are unlikely to result in the emission of observable light due to the refraction occurring at the light emitting surface 12. Thus, the reflection at angles of incidence above 20° does not impact on the output of observable light by the light emitting device array 1.

As shown in Fig. 6a, the thickness of the anti-reflection layer 20 is selected in order to provide a quarter wavelength anti-reflection layer 20. As such, the thickness of the anti-reflection layer is selected to be $\lambda_0$ /4 $n_p$, where $n_p$ is the refractive index of the anti-reflection layer 20 at $\lambda_0$. In embodiments where the anti-reflection layer 20 is provided by a porous semiconducting layer, the refractive index of the porous semiconducting layer $n_p$, may depend upon the porosity of the porous semiconducting layer. In general, as the porosity of the porous semiconducting layer is increased, the refractive index of the porous semiconducting layer may be reduced. For example, in some embodiments where the porous semiconducting layer comprises GaN the following relationship between the areal porosity and the refractive index may be found in Table 1 below.

**Table 1**

| *Porosity* | *$n_p$ @ 450nm* |
|---|---|
| *0%* | *2.44* |
| *10.0%* | *2.34* |
| *20.0%* | *2.23* |
| *30.0%* | *2.12* |
| *40.0%* | *2.00* |
| *50.0%* | *1.87* |
| *60.0%* | *1.73* |
| *70.0%* | *1.58* |
| *80.0%* | *1.41* |
| *90.0%* | *1.22* |

As such, the thickness of the porous semiconducting layer acting as an anti-reflection layer 20 will be dependent on the wavelength of the first wavelength, and also the porosity of the semiconducting layer. In some embodiments, a porous semiconducting layer having an areal porosity of at least 60% and/or no greater than an areal porosity of 80% may be selected such that the refractive index is around x-y. In the embodiment shown in Fig. 6a the porous semiconducting layer has an areal porosity of 70%.

In some embodiments, the anti-reflection layer may 20 be provided by a stack of porous semiconducting sublayers. The stack of porous semiconducting sublayers may have different porosities, such that the refractive index through the anti-reflection layer 20 varies. Each porous semiconducting sublayer is formed form a corresponding third semiconducting sublayer by subject the semiconducting sublayer to a porosity treatment process. The (areal) porosity of a semiconducting sublayer may be controlled through control of the doping density of the respective third semiconducting sublayer, as discussed in more detail below. The porosity of each porous semiconducting sublayer may be selected to provide each porous semiconducting sublayer with a desired refractive index. Further, the thickness (in a direction normal to the light emitting surface 12) of each porous semiconducting sublayer, and the number of porous semiconducting sublayers, may each be selected to provide an antireflection layer 20 with the desired optical properties.

By forming the anti-reflection layer 20 from a porous semiconducting layer it is possible to form the precursor material to the porous semiconducting layer as part of the process of forming the light emitting stack 10. As such, a method of forming the light emitting device array 1 may include forming a third semiconducting layer on the light emitting surface 12. The third semiconducting layer comprises a Group-III nitride and has a donor density of at least $1 \times 10^{18}$ $cm^{-3}$. As such, the third semiconducting layer is a relatively highly doped Group-III nitride semiconductor. The third semiconducting layer may be doped to have a higher doping concentration than the first semiconducting layer such that a subsequent porosity treatment process selectively affects the third semiconducting layer and not the first semiconducting layer 13 in order to provide a distinct boundary between the anti-reflection layer 20 and the first semiconducting layer 13. For example, in the first embodiment, the first semiconducting layer 13 has a n-type doping density of at least $1 \times 10^{17}$ $cm^{-3}$ and no greater than $1 \times 10^{18}$ $cm^{-3}$, and the third semiconducting layer is formed with a n-type doping density of at least $1 \times 10^{18}$ $cm^{-3}$, preferably at least $5 \times 10^{18}$ $cm^{-3}$.

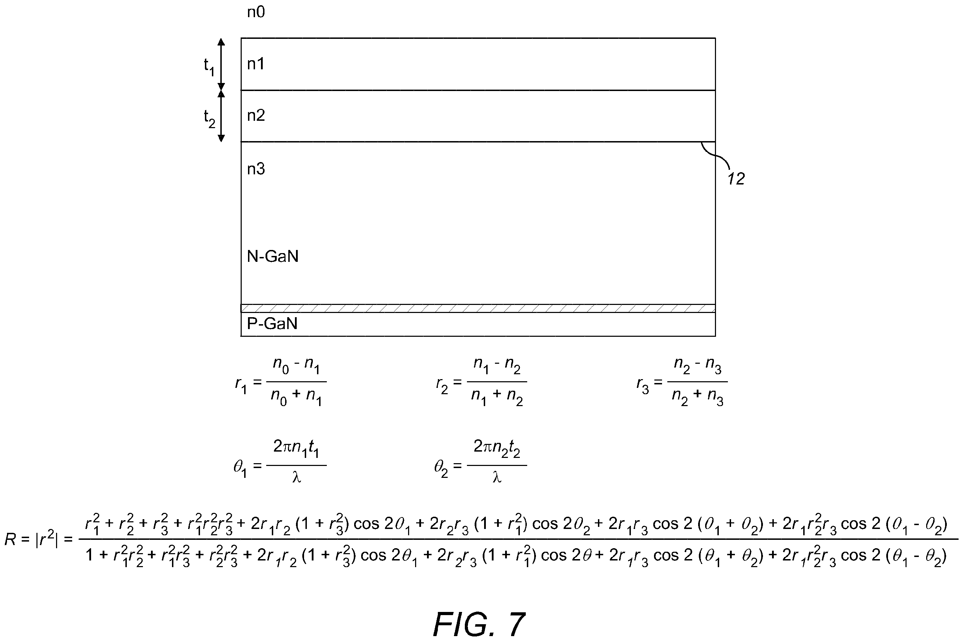

In the embodiment of Fig. 1, the anti-reflection layer 20 is configured to account for the presence of the common first contact layer 40, which in Fig. 1 is provided by a transparent conductive oxide layer. Fig. 7 shows a diagram of a light emitting stack with 10 with two layers provided on the light emitting surface 12. For example, in accordance with the first embodiment of the disclosure, the two layers may be the anti-reflection layer 20 and the common first contact layer 40 which comprises a transparent conductive oxide.

Next, the design of the antireflection layer 20 will be discussed for embodiments where two layer are present on the light emitting surface (such as in the first embodiment). As shown in Fig. 7, a third refractive index of the first semiconducting layer 13 is $n_3$, a second refractive index of the first layer provided on the light emitting surface 12 (e.g. the anti-reflection layer 20) is $n_2$, and a first refractive index of the second layer (e.g. the transparent conductive oxide layer) provided on the first layer is $n_1$. The first layer (e.g. the antireflection layer 20) has a thickness in the direction normal to the light emitting surface 12 of $t_2$. The second layer (e.g. the transparent conductive oxide layer) has a thickness $t_1$ in the direction normal to the light emitting surface 12.

Given the arrangement shown in Fig. 7, the following parameters may be defined, where $\lambda$ is the wavelength of light emitted by the active layer 14:

$$r_1 = \frac{n_0 - n_1}{n_0 + n_1} \qquad r_2 = \frac{n_1 - n_2}{n_1 + n_2} \qquad r_3 = \frac{n_2 - n_3}{n_2 + n_3}$$

$$\theta_1 = \frac{2\pi n_1 t_1}{\lambda} \qquad \theta_2 = \frac{2\pi n_2 t_2}{\lambda}$$

Accordingly, the reflectivity (R) of the two-layer coating on the light emitting surface 12 for light of a wavelength $\lambda$ at normal incidence to the light emitting surface may be calculated as:

$$R = |r^2| = \frac{\mathrm{M}}{\mathrm{N}}$$

Where:

$$\mathrm{M} = r_1^2 + r_2^2 + r_3^2 + r_1^2 r_2^2 r_3^2 + 2r_1 r_2 \left(1 + r_3^2\right) \cos 2\theta_1 - 2r_2 r_3 \left(1 + r_1^2\right) \cos 2\theta_2 + 2r_1 r_3 \cos 2\left(\theta_1 - \theta_2\right) - 2r_1 r_2^2 r_3 \cos 2\left(\theta_1 - \theta_2\right)$$

$$\mathrm{N} = 1 + r_1^2 r_2^2 + r_1^2 r_3^2 + r_2^2 r_3^2 + 2r_1 r_2 \left(1 + r_3^2\right) \cos 2\theta_1 - 2r_2 r_3 \left(1 + r_1^2\right) \cos 2\theta + 2r_1 r_3 \cos 2\left(\theta_1 - \theta_2\right) - 2r_1 r_2^2 r_3 \cos 2\left(\theta_1 - \theta_2\right)$$

Using the above equation, the anti-reflection layer 20 may be configured to reduce reflection of light of the first wavelength at the interface between the light emitting surface 12 light emitting stack 10 and the surroundings (i.e. air).

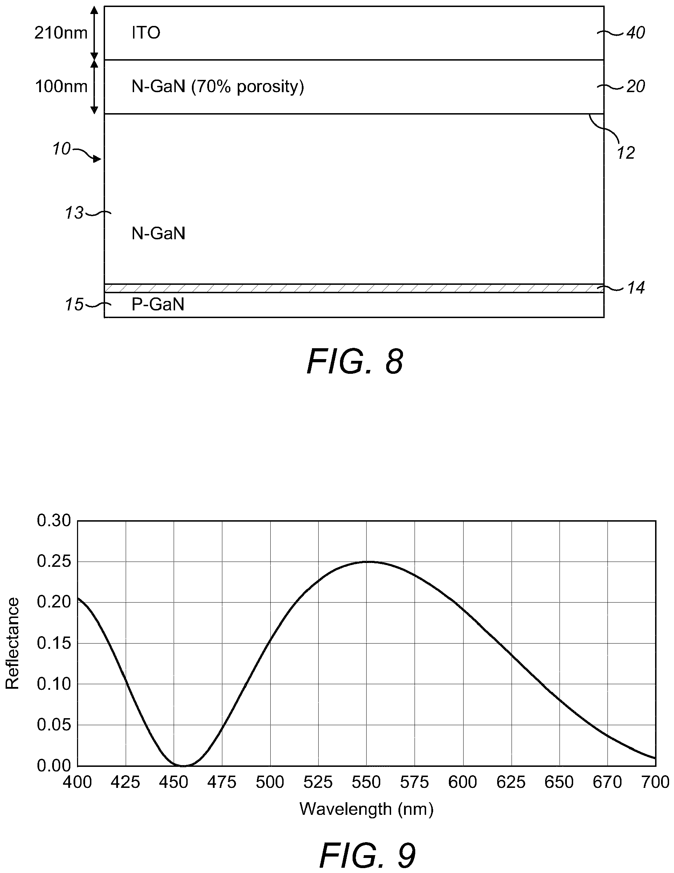

Some possible examples of the anti-reflection layer 20 and the common first contact layer 40 will now be described with reference to Figs. 8 to 13. In Fig. 8, a diagram of a light emitting stack 10 with an anti-reflection layer 20 and a common first contact layer 40 comprising ITO is shown. In the example of Fig. 8, the ITO layer has a thickness $t_1$ of 210 nm and a refractive index $n_1$ of 2.03 at 455 nm. In accordance with the calculation set out above, the anti-reflection layer 20 is provided by a 70 % areal porosity porous semiconducting layer ($n_2$ = 1.58 at 450 nm) having a thickness $t_2$ of 100 nm. Such an anti-reflection layer 20 provides a reflectance R of about 0 for light of a wavelength $\lambda$ = 455 nm. A graph of the reflectance of the structure shown in Fig. 8 is shown in Fig. 9.

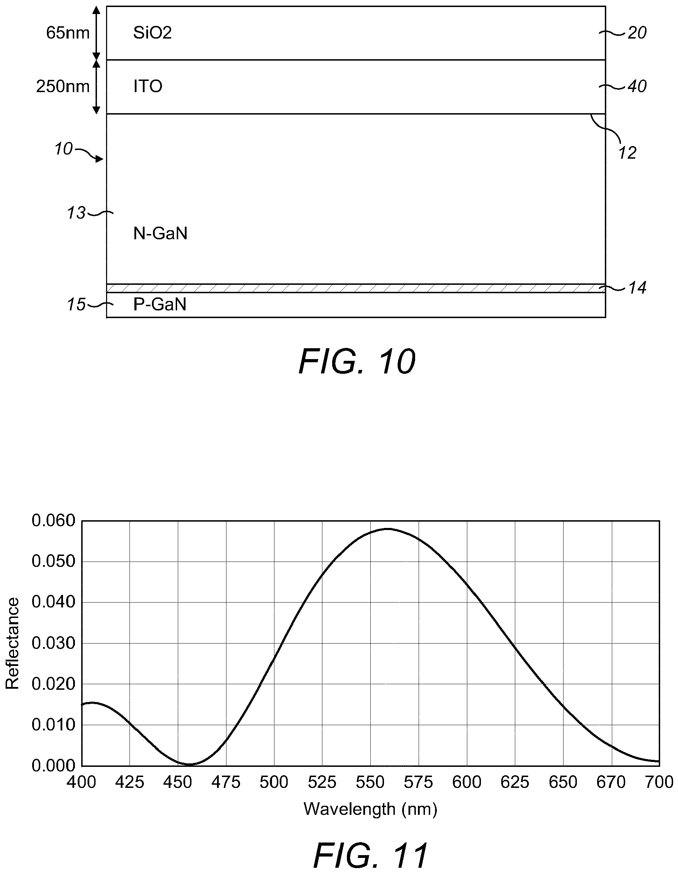

As discussed above, the anti-reflection layer 20 and the common first contact layer 40 may both be provided on the light emitting surface 12. In the first embodiment, the anti-reflection layer 20 is provided directly in contact with the light emitting surface 12 of the light emitting stack 12, such that the anti-reflection layer 20 is provided between the light emitting stack 10 and the common first contact layer 40. In some embodiments, the common first contact layer 40 and the anti-reflection layer 20 may be provided in the opposite arrangement. For example, as shown in Fig. 10, the common first contact layer 40 is provided directly in contact with the light emitting surface 12 of the light emitting stack 10. The anti-reflection layer 20 is provided on the first contact layer 40. As such, the first contact layer 40 is provided between the light emitting stack 10 and the anti-reflection layer 20.

In the example of Fig. 10, the ITO layer has a thickness $t_2$ of 250 nm and a refractive index $n_2$ of 2.03 at 455 nm. In accordance with the calculation set out above, the anti-reflection layer 20 is provided by a $SiO_2$ layer ($n_1$ = 1.47 at 455 nm) having a thickness $t_1$ of 65 nm. Such an anti-reflection layer 20 provides a reflectance R of about 0 for light of a wavelength $\lambda$ = 455 nm. A graph of the reflectance of the structure shown in Fig. 10 is shown in Fig. 11.

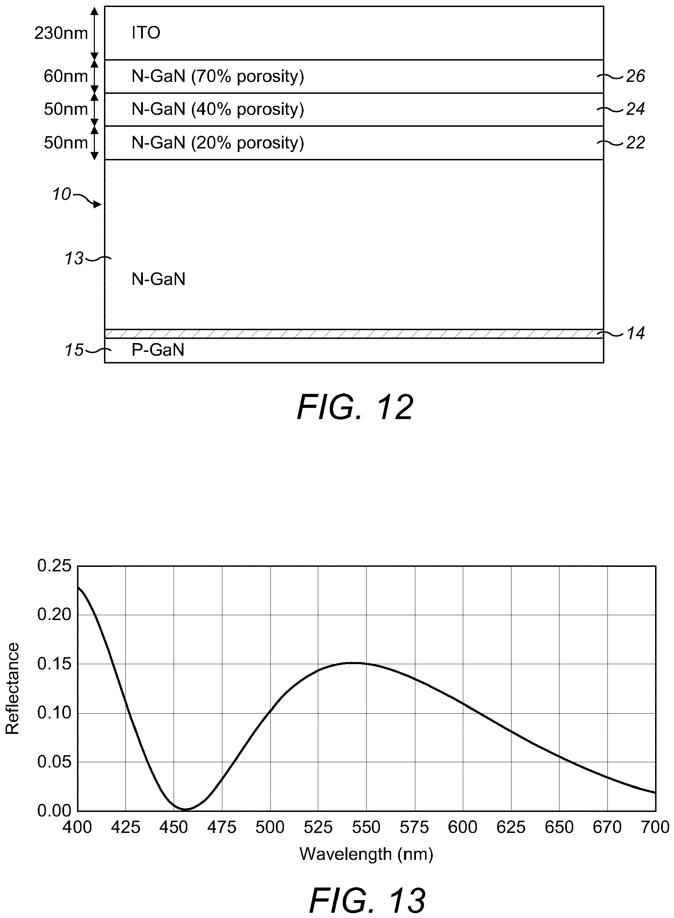

In some embodiments, the anti-reflection layer 20 may comprise a plurality of anti-reflection sublayers 22, 24, 26. An example of such an anti-reflection layer 20 is shown in Fig. 12. As shown in Fig. 12, the anti-reflection layer 20 comprises a first anti-reflection sublayer 22, a second anti-reflection sublayer 24, and a third anti-reflection sublayer 26. The anti-reflection sublayers are arranged sequentially from the light emitting surface 12. The plurality of anti-reflection sublayers 22, 24, 26, provide an anti-reflection layer 20 with a graded refractive index. As such, the refractive index of the anti-reflection layer 20 is graded such that it decreases in the direction normal to the light emitting surface 12. The decrease in refractive index is achieved by varying the porosity of the anti-reflection sublayers. In the embodiment of Fig. 12, the refractive index decreases from 2.23 (20 % porosity) to 1.58 (70 % porosity). The refractive index decreases in a step-wise manner due to the plurality of anti-reflection sublayers 22, 24, 26. In other embodiments, a graded refractive index may be provided by smoothly varying the porosity of the anti-reflection layer 20. Other possible variations in refractive index may also be provided, for example an increase in refractive index, alternating values of refractive index or any combination of increases and decreases.

In the example of Fig. 12, the ITO layer has a thickness $t_1$ of 210 nm and a refractive index $n_1$ of 2.03 at 455 nm The first anti-reflection sublayer 22 is a porous semiconducting layer having an areal porosity of 20 % (n = 2.23) and a thickness of 50 nm. The second anti-reflection sublayer 24 is a porous semiconducting layer having an areal porosity of 40 % (n = 2.00) and a thickness of 50 nm, The third anti-reflection sublayer 26 is a porous semiconducting layer having an areal porosity of 70 % (n = 2.23) and a thickness of 60 nm. Such an anti-reflection layer 20 provides a reflectance R of about 0 for light of a wavelength $\lambda$ = 455 nm. A graph of the reflectance of the structure shown in Fig. 12 is shown in Fig. 13.

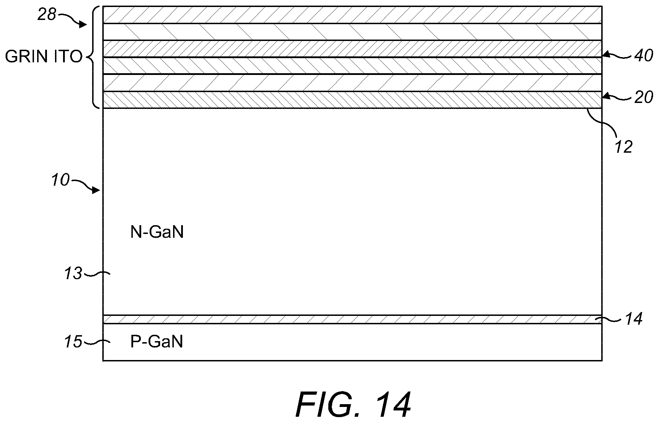

It will be appreciated from the examples of Fig. 8 and Fig. 10 that the relative positions of the anti-reflection layer 20 and the common first contact layer 40 may be swapped. It will also be appreciated from the example of Fig. 12 that a layer having a graded refractive index may be provided on the light emitting surface 12 in order to provide the desired optical properties. Following on from these concepts, Fig. 14 shows an example where the anti-reflection layer 20 and the common first contact layer 40 form a graded refractive index (GRIN) structure 28 having both anti-reflection and electrical contact functionality. In the example of Fig. 14, the GRIN structure 28 comprises a plurality of layers. At least one of the plurality of layers provides the common first contact layer 40, whilst at least one other layer provides the anti-reflection layer 20. In the GRIN structure 28, each of the plurality of layers comprises the same transparent conductive oxide, for example ITO. The plurality of layers are formed in order to provide a graded refractive index, similar to the example of Fig. 12. As such, the plurality of layers are formed in order to provide a variable refractive index which decreases towards 1 in a direction normal to the light emitting surface.

The refractive index of the transparent conductive oxide may be varied through variation in the porosity of the transparent conductive oxide. One known method for varying the porosity of a transparent conductive oxide, such as ITO, is oblique-angle deposition using electron-beam evaporation. By varying the angle of the deposition surface relative to the vapour flu deposition, the amount of shadow cast by as-deposited material may be controlled, thereby controlling the porosity of the as-formed layer. Further explanation of oblique angle deposition for ITO may be found in at least "Light-Extraction Enhancement of GaInN Light Emitting Diodes by Graded-Refractive-Index Indium Tin Oxide Anti-Reflection Contact", Jong Kyu Kim et. al., Advanced Materials, 0000, 00, 1-5.

In the example of Fig. 14 the GRIN structure 28 comprises 6 different layers. Each layer comprises ITO having a different refractive index. The refractive index of the 6 layers may vary from around 2.2 at the light emitting surface, to around 1.2 at the interface with free space. For example, the refractive index of the 6 different layers may be selected to be 2.2, 2.0, 1.8, 1.5, 1.3 and 1.2. Of course, the thicknesses and the refractive index of the GRIN structure 28 may be varied depending on the first wavelength of light emitting by the active region 14.

Next, a method of forming a light emitting device array 1 according to the first embodiment will be described. The method comprises forming a light emitting stack 10 on a substrate surface of a substrate. The substrate may be any substrate suitable for the formation of Group-III nitrides. For example, the substrate may comprise a Si wafer, or a Sapphire wafer.

The light emitting stack 10 is formed such that a light emitting surface 12 of the light emitting stack 10 is orientated towards the substrate surface. A contact surface 11 of the light emitting stack 10 is provided on an opposing side of the light emitting stack 10. As such, the contact surface 11 is orientated away from the substrate surface (relative to the light emitting surface 12).

Forming the light emitting stack 10 comprises forming a plurality of Group-III nitride layers on the substrate surface. The layers of the light emitting stack 10 include a first semiconducting layer 13, an active layer 14, and a second semiconducting layer 15. The first semiconducting layer 13, the active layer 14 and the second semiconducting layer 15 are formed sequentially such that the active layer 14 is provided between the first semiconducting layer 13 and the second semiconducting layer 15. As discussed above, the first semiconducting layer 13, the second semiconducting layer 15 and the active layer 14 may be formed using an MOCVD process or a MBE process as discussed above. As discussed in relation to the first embodiment and Fig. 1 above, the light emitting surface and the contact surface 11 of the light emitting stack 10 are formed such that they are parallel to each other and aligned with the plurality of Group-III nitride layers.

Following the formation of the light emitting stack 10, an array of second electrical contacts 30 are formed on the contact surface 11 of the light emitting stack 10. Each second electrical contact 30 defines a light emitting device between the first semiconducting layer 13 and the second electrical contact 30. Each of the second electrical contacts 30 are spaced apart from the other second electrical contacts 30 to form a two-dimensional array of light emitting devices. The second electrical contacts 30 may be formed as discussed in more detail above.

Following the formation of the second electrical contacts 30 the substrate may be removed from the light emitting stack. Following the removal of the substrate, a common first contact layer 40 may then be formed on the light emitting stack 10. For example, in the first embodiment, the common first contact layer 40 may be formed as a transparent conductive oxide over the light emitting surface 12 of the light emitting stack 10. The common first contact layer 40 is configured to be in electrical contact with the first semiconducting layer 13 of the light emitting stack 10.

An anti-reflection layer 20 is also formed on the light emitting surface 12. The anti-reflection layer 20 may, in some embodiments, be formed on the light emitting surface 12 following the removal of the substrate. The anti-reflection layer 20 may be formed on the light emitting surface 12 prior to the formation of the common first contact layer 40. In other embodiments, for example as shown in Fig. 10, the anti-reflection layer 20 may be formed on the common first contact layer 40. In some embodiments, the anti-reflection layer 20 may comprise a porous semiconducting layer. In other embodiments, the anti-reflection layer may comprise $SiO_2$, or ITO, or any other material with a suitable refractive index.

In some embodiments the anti-reflection layer comprises a porous semiconducting layer. Such an anti-reflection layer 20 may be formed by forming a third semiconducting layer on the substrate surface of the substrate prior to the formation of the light emitting stack 10. The third semiconducting layer may comprise a Group III-nitride, for example GaN, which is doped with an n-type dopant. In some embodiments, the third semiconducting layer is formed from the same Group III-nitride as the first semiconducting layer 13, wherein the doping density of the third semiconducting layer is varied relative to the first semiconducting layer 13. The light emitting stack 10 is then formed on the exposed surface of the third semiconducting layer as described above. Following the removal of the substrate as part of the method of forming the light emitting device array 1, the third semiconducting layer may then be subjected to a porosity treatment process in order to form the anti-reflection layer 20 as a porous semiconducting layer. As such, it will be appreciated that the formation of the anti-reflection layer 20 may be integrated into the process for forming the Group-III nitride layers forming the light emitting stack 10. As such, the formation of the anti-reflection layer 20 may be integrated as part of an alignment-free process for forming the Group-III nitride layers of the light emitting device array 1.

As discussed above, the anti-reflection layer 20 may be provided by a porous semiconducting layer. The porous semiconducting layer may be formed by subjecting a third semiconducting layer to a porosity treatment process. The porosity treatment process may be performed following the formation of the light emitting stack 10. The porosity treatment process is configured to increase the porosity (areal porosity) of the third semiconducting layer. Methods for increasing the porosity of a Group III-nitride layer are known to the skilled person. For example, "In-plane bandgap control in porous GaN through electroless wet chemical etching", Xiuling Li, Young Woon-Kim et al., Applied Physics Letters, Vol. 8, no. 6, 11 February 2002, describes several processes for increasing the porosity of an n-type doped Group III-nitride layer.

For example, the porosity treatment process may comprise subjecting the third semiconducting layer (and the layers of the light emitting stack 10) to an electrochemical treatment process. The electrochemical treatment process may comprise submerging the third semiconducting layer in a bath of oxalic acid. Electrical connections are made between the bath of oxalic acid and the third semiconducting layer. An electric current is passed between the electrical contacts of the oxalic acid bath and the third semiconducting layer in order to electrochemically form pores within the third semiconducting layer. In some embodiments, the oxalic acid baths comprises an oxalic acid solution having a concentration of between 0.03M and 0.3M. In other embodiments, the oxalic acid bath may be substituted for other electrolytes such as KOH or HCl. The level of electrical bias applied to the electrochemical process will depend on the electrochemical solution used and the relative dimensions of the bath and the third semiconducting layer/light emitting stack 10. Further examples of porosity treatments are described in ACS Applied Nano Materials, 2020, 3, 399-402 and US 2017/0237234.

The porosity treatment process results in the formation, or an increase in the size of, pores present in the third semiconducting layer. The porosity of the third semiconducting layer may be characterised by an areal porosity. Areal porosity is the area fraction of pores present in a cross-section through the material (i.e. through the third semiconducting layer). In some embodiments, the porous semiconducting layer has an areal porosity of at least 30%. In some embodiments, the porous semiconducting layer has an areal porosity of at least 40%. In some embodiments, the porous semiconducting layer 14' has an areal porosity of no greater than 80 %. By providing the porous semiconducting layer with such an areal porosity, the third semiconducting have a refractive index which is suitable for forming an antireflection layer 20.

In some embodiments, the method may also further comprise forming an absorbing layer 50 on at least a portion of the light emitting stack 10. The absorbing layer 50 may be formed on the sidewall surfaces of the light emitting stack.

Accordingly, it will be appreciated that the method described above may be used to provide a light emitting device array 1 in accordance with the first embodiment of the disclosure.

Next, a light emitting device array 2 according to a second embodiment of the disclosure will be described.

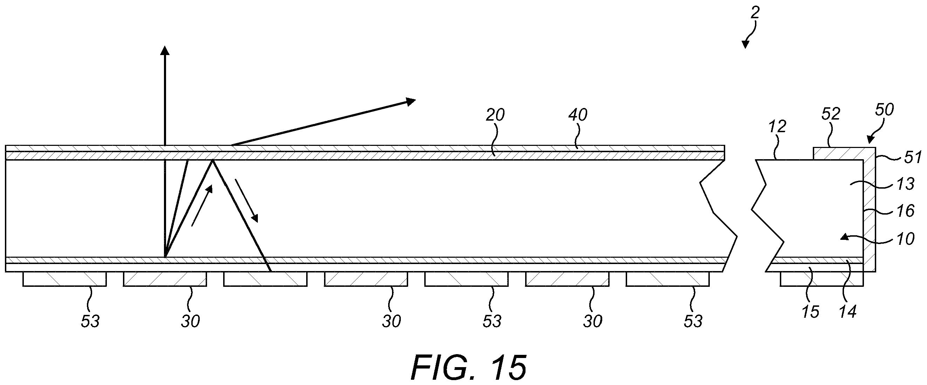

The light emitting device array 2 according to the second embodiment of the disclosure comprises a light emitting stack 10, an anti-reflection layer 20, an array of second electrical contacts 30, and a common first contact layer 40. These features are similar to the features described above in relation to the first embodiment. An example of a cross-section of a light emitting device array 2 according to a second embodiment of the disclosure is shown in Fig. 15.

As shown in Fig. 15, the light emitting device array 2 comprises an absorbing layer 50. The absorbing layer 50 comprises a first portion 51 which covers substantially the entire sidewall surface 16 of the light emitting stack 10 in a manner similar to that described for the first embodiment. A second portion of the absorbing layer 52 may also be provided around the perimeter of the light emitting surface 12 in a manner similar to the first embodiment.

In the second embodiment of the disclosure, a third portion of the absorbing layer 53 is provided on the contact surface 11. The third portion of the absorbing layer 53 is provided in regions of the contact surface 11 between adjacent second electrical contacts of the array of second electrical contacts 30. As shown in Fig. 15, the third portion of the absorbing layer 53 may be spaced apart from the second electrical contacts 30 in order to prevent shorting between the second electrical contacts 30. The third portions of the absorbing layer 53 provide additional absorbing regions for light generated in the active layer. The third portions of the absorbing layer 53 may be provided to absorb light which has been reflected from the light emitting surface 12 at an angle less than the critical angle or light which has been generated in the active layer 14 which is directly incident on the contact surface 11. By absorbing such stray light, the possibility of the stray light being reflected towards the light emitting surface 12 and possibly emitted is reduced, thereby further reducing any appearance of cross talk between adjacent light emitting devices 1.

The third portions 53 of the absorbing layer 50 may be formed in a similar manner to the first and second portions of the absorbing layer 50. The third portions of the absorbing layer 53 may be formed using any suitable patenting technique such as lithography. The third portions of the absorbing layer may be formed either before the formation of the second electrical contacts 30 or after the formation of the second electrical contacts 30. In some embodiments, the third portions of the absorbing layer 53 effectively define a grid comprising a plurality of openings in which the second electrical contacts 30 are provided. As the formation of such a grid may require an additional patenting step in some embodiments, the third portions of the absorbing layer 53 may not be provided.

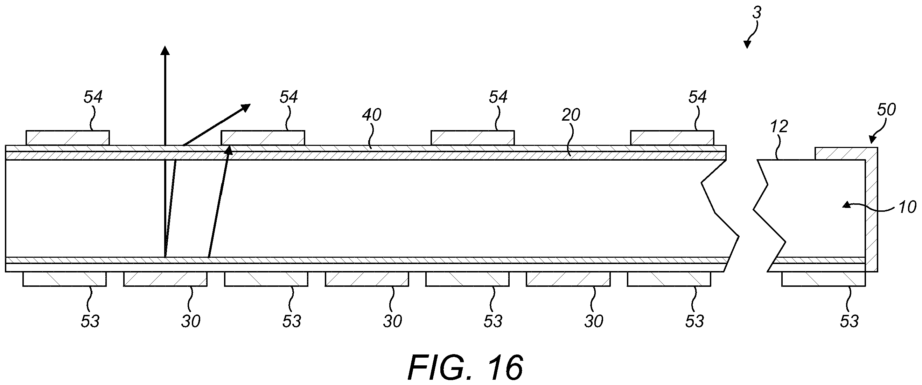

Next, a third embodiment of the light emitting device array 3 will be described. A cross-sectional diagram of a third embodiment of the light emitting device array 3 is shown in Fig. 16. As shown in Fig. 16, the light emitting device array 3 comprises a light emitting stack 10, an anti-reflection layer 20, an array of second electrical contacts 30, a common first contact layer 40, and an absorbing layer 50. Similar to the second embodiment, the absorbing layer 50 comprises a first portion 51, a second portion 52, and a third portion 53.

In the third embodiment of the light emitting device array 3, the absorbing layer 50 also comprises a fourth portion 54. The fourth portion of the absorbing layer 54 is provided on the light emitting surface 12 as a generally continuous layer comprising a plurality of openings through a thickness of the fourth portion of the absorbing layer 54. Each opening through the fourth portion of the absorbing layer 54 is aligned with a second electrical contact such that light from each light emitting device travelling in a direction generally normal to the light emitting surface can travel through a respective opening. As shown in Fig. 16, the fourth portions of the absorbing layer 54 on the light emitting surface 12 are generally aligned with the third portions 53 of the absorbing layer provided on the contact surface 11. As such, the openings provided by the fourth portion of the absorbing layer 54 may be similar to the openings provided by the grid of the third portions of the absorbing layer 53 for the second electrical contacts 30. In some embodiments, the grid formed by the third portions of the absorbing layer 53 may be the same as the grid formed by the fourth portions of the absorbing layer 54. That is to say, in some embodiments the same mask pattern may be used to form the third and fourth portions 53, 54 of the absorbing layer 50. Of course, in other embodiments the third portion of the absorbing layer 53 and the fourth portion of the absorbing layer 54 may be formed using different patterns.

The fourth portion of the absorbing layer 54 is provided on the light emitting surface 12 in order to define a plurality of openings through which light may be emitted. Light is not emitting from the light emitting surface 12 in regions covered by the fourth portions of the absorbing layer 54. As such, the fourth portions of the absorbing layer 54 may be provided to further reduce and/or eliminate cross talk between adjacent light emitting devices.

As discussed above, the second and third embodiments of the disclosure have absorbing layers 20 and common first contact layers 40 which are similar to those described for the first embodiment. It will be appreciated that in other embodiments of the disclosure, other absorbing layers 20 and other first electrical contact layers may be provided. For example, the skilled person will appreciate that the second and third embodiments may be combined with any of the absorbing layers 20 and common first contact layers 40 discussed above in relation to Figs. 7 to 14.

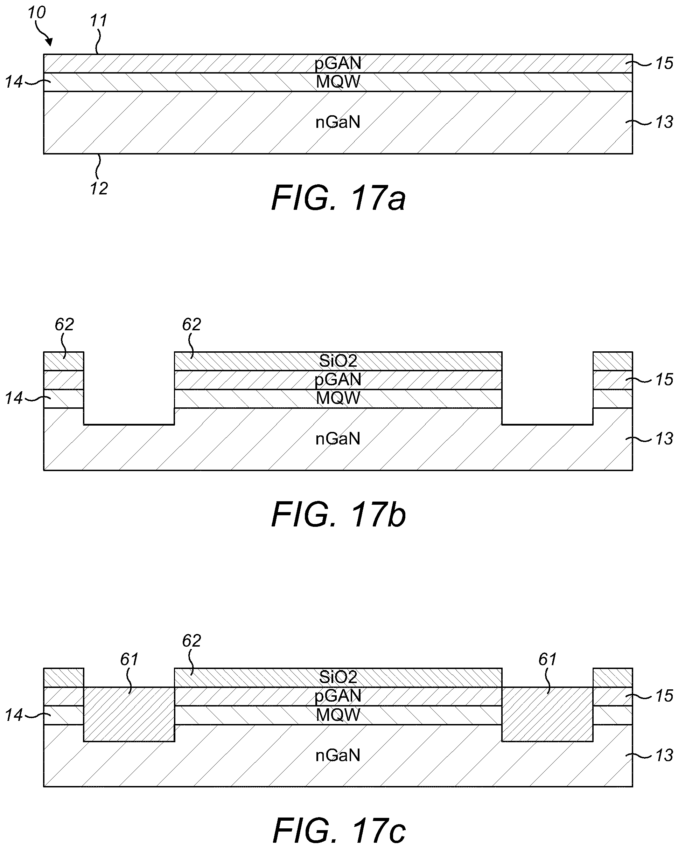

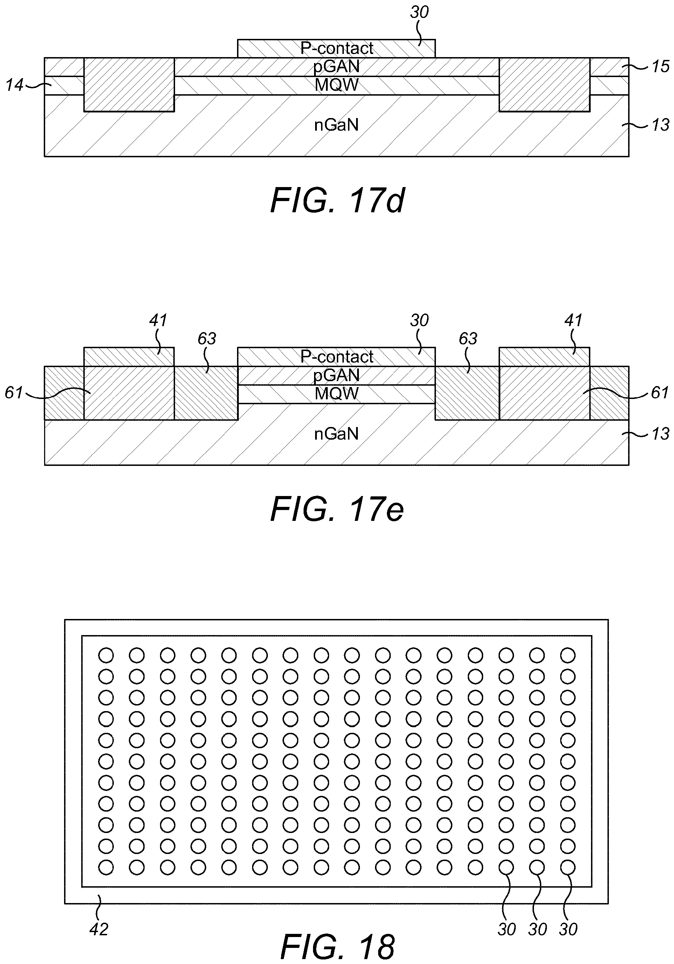

Next, a fourth embodiment of the light emitting device array 4 will be described with reference to Figs. 17a, 17b, 9c, 17d and 17e. In the first, second and third embodiments of the disclosure, the common first contact layer 40 is provided using a transparent conductive oxide, provided on the light emitting surface 12 of the light emitting stack 10. According to the fourth embodiment of the disclosure the common first contact layer 40 may also be provided using an electrical contact located from the contact surface side of the light emitting stack 10. Such a process allows both the first and second electrical contacts for the light emitting device array 4 to be located on the same surface (i.e. the contact surface 11) such that the light emitting device array 4 may be more easily connected to control electronics. For example, the light emitting device array 4 of the fourth embodiment may be bonded to a back plane electronics array using a suitable bonding technology.

Figs. 17a through 17e shown a process for forming a common first electrical contact on the contact surface 11 of the light emitting stack 10. For simplicity, the other layers of the light emitting device array 4 are not shown, but it will be appreciated that they may be formed by any of the methods described above in relation to the first, second and third embodiments of the disclosure.

As shown in Fig. 17a, a light emitting stack 10 is provided. The light emitting stack 10 may be formed on a substrate in a manner similar to the embodiments described above. The light emitting stack 10 comprises a first semiconducting layer 13, an active layer 14, and a second semiconducting layer 15. In order to form an electrical connection between the contact surface 11 and the first semiconducting layer 13, a via semiconducting portion 61 is provided in the light emitting stack 10 which extends through the active layer 14 between the first semiconducting layer 13 and the contact surface 11. A first electrical contact portion 41 is then provided on the contact surface 11 which is aligned with the via semiconducting portion 61 in order to make an electrical connection to the first semiconducting layer 13. An example of such a via semiconducting portion 61 is shown in Fig. 17e.

As shown in Figs. 17b and 17c, a via semiconducting portion may be formed by selectively removing a portion of the light emitting stack 10 from the contact surface through to the first semiconducting layer 13. The selective removal process may be performed following the formation of the light emitting stack 10, and preferably prior to removal of the substrate (not shown). The selective removal process may include the patterning of the contact surface 11 using a masking layer 62. The masking layer may define one or more openings which define regions of the light emitting stack 10 to be selectively removed. The masking layer 62 may comprise any material suitable for use as a mask for a selective removal process. For example, in the embodiment of Figs. 17a-17e, the masking layer 62 comprises $SiO_2$. The masking layer may be formed by any suitable method, for example Chemical Vapour Deposition. The masking layer may be patterned using any suitable technique, for example lithography.

Following the formation of the masking layer 62, the light emitting stack 10 may be subjected to a selective removal process, for example etching, to form a void in which the via semiconducting portion 61 is to be formed. An example of such a void is shown in Fig. 17b.

The via semiconducting portion 61 may then be formed within the void, for example as shown in Fig. 17c. In the embodiment of Fig. 17c, the via semiconducting portion 61 comprises the same material as the first semiconducting layer 13, which in Fig. 17c is n-type doped GaN. As such, the via semiconducting portion 61 is regrown on the first semiconducting layer 13 to provide a n-type doped semiconducting region on the contact surface 11.

Following the formation of the via semiconducting portion 61, the masking layer 62 is removed and the second electrical contacts 30 are formed on the contact surface 11. As shown in Fig. 17d, the second electrical contacts 30 are formed on the regions of the contact surface 11 provided by the second semiconducting layer 15, and not on the via semiconducting portions 61.

First electrical contacts 41 are formed on the via semiconducting portions 61 to provide contacts to the first semiconducting layer 13. An example of the first electrical contacts is shown in Fig. 17e. As such, according to the fourth embodiment the first and second electrical contacts 41, 30 may be provided on the same surface (the contact surface 11) of the light emitting stack 10. The first electrical contacts 41 may comprise any suitable material for forming an Ohmic contact to the (n-type) via semiconducting portions 61.

Following the formation of the first electrical contacts 61, the contact surface 11 may be subjected to an ion implantation process. The ion implantation process may affect the exposed regions of the second semiconducting layer 15 between the first and second electrical contacts 41, 30. The ion implantation process may disrupt the crystal structure of the light emitting stack 10 in these regions to improve electrical isolation between the via semiconducting portions 61 and the light emitting devices. As such, the light emitting stack 10, for example as shown in Fig. 17e may comprise ion implanted regions 63 between the via semiconducting portions 61 and the light emitting devices. As such, the ion implanted regions 63 may effectively encircle the via semiconducting portions 61 in the light emitting device stack 10.

Thus, the fourth embodiment provides a light emitting device array 4 with first and second electrical contacts 41, 30 provided on a contact surface 11. The skilled person will appreciate that the embodiment shown in Figs. 17a-17e is only one possible arrangement for the first and second electrical contacts 41, 30. The skilled person will appreciate that the layout of the contacts may be adjusted depending on the device size, device arrangement and so on.

As an example, Fig. 18 provides a further example of one possible arrangement of a common first electrical contact and an array of second electrical contacts 30 according to embodiments of this disclosure. As shown in Fig. 18, the common first electrical contact is provided as a perimeter first electrical contact 42. The perimeter first electrical contact 42 surrounds all of the second electrical contacts 30. The perimeter first electrical contact can be provided on the contact surface 11 of the light emitting stack 10, aligned with a corresponding via semiconducting portion 61. In some embodiments, the perimeter first electrical contact 42 could be provided on the light emitting surface 12, as an alternative to a transparent electrical contact. A perimeter first electrical contact 42 may particularly be used in embodiments where the number of light emitting devices in the array is no greater than 1000 in each dimension. As such, for light emitting device arrays having no greater than 1000 $\times$ 1000 light emitting devices, the surface area of the light emitting device array is such that a perimeter contact can deliver sufficient current to all of the light emitting devices in the array. In particular, for arrays where the pitch is no greater than 5 $\mu$m, it will be appreciated that such an array having no greater than 1000 light emitting devices has a light emitting surface of no greater than about 5 mm. In some embodiments, where a light emitting array has around 400 $\times$ 600 light emitting devices with a pixel pitch of 1 $\mu$m, a light emitting device array of around 0.4 mm $\times$ 0.6 mm may be provided.

In the diagram of Fig. 18, the perimeter first electrical contact 42 is shown extending around the perimeter as a continuous loop. Of course, in other embodiments, the perimeter first electrical contact 42 may not be a continuous loop. For example, a c-shaped perimeter first electrical contact 42 may be suitable. Effectively, the perimeter electrical contact 42 defines an opening on the light emitting surface 12, wherein the opening is aligned with the array of second electrical contacts 30.

In Fig. 18, the second electrical contacts 30 are shown as circular contacts. Of course, other shapes for the second electrical contacts may also be suitable.

Thus, according to embodiments of this disclosure a light emitting device array and a method of forming a light emitting device array are provided. The light emitting device arrays of this disclosure may be formed using minimal patterning steps, thereby reducing or eliminating the alignment steps during the formation of the light emitting device array. Reducing, or eliminating alignment steps is particularly advantageous for small pitch devices (e.g. devices having a pitch of no greater than 5 $\mu$m) as it increases the area available for forming the light emitting device.

The light emitting area for each device is also increased by using the array of second electrical contacts on the contact surface to define each light emitting device. As such, embodiments of the present disclosure seek to increase the size of the active region for each light emitting device relative to the overall light emitting device pitch.

Although embodiments of the disclosure have been described herein in detail, it will be understood by those skilled in the art that variations may be made thereto without departing from the scope of the invention defined by the appended claims.

## Claims

**1.** A light emitting device array (1) comprising:

a light emitting stack (10) having a light emitting surface (12) and a contact surface (11), the light emitting surface (12) and the contact surface (11) defining opposing sides of the light emitting stack (10),

the light emitting stack (10) comprising a plurality of Group III-nitride layers including a first semiconducting layer (13) provided towards the light emitting surface (12) of the light emitting stack (10), a second semiconducting layer (15) provided towards the contact surface (11), and an active layer (14) arranged between the first semiconducting layer (13) and the second semiconducting layer (15), the active layer (14) configured to generate light having a first wavelength,
wherein the light emitting surface (12) and the contact surface (11) are parallel to each other and aligned with the plurality of Group III-nitride layers;
a first electrical contact layer (40) provided on the light emitting stack (10) and configured to be in electrical contact with the first semiconducting layer (13);
an array of second electrical contacts (30) provided on the contact surface (11) of the light emitting stack (10), each second electrical contact (30) defining a light emitting device between the first semiconducting layer (13) and the second electrical contact (15), wherein each of the second electrical contacts (30) is spaced apart from the other second electrical contacts (30) to form a two-dimensional array of the light emitting devices; **characterised in** further comprising:
an anti-reflection layer (20) provided on the light emitting surface (12), the anti-reflection layer (20) configured to increase a light extraction efficiency of light generated by the light emitting stack (10).

**2.** A light emitting device array (1) according to claim 1, further comprising

an absorbing layer (50) configured to absorb light of the first wavelength generated by the active layer (14); the absorbing layer (50) provided on at least a portion of the light emitting stack (10), wherein optionally
the absorbing layer (50) is provided on at least one sidewall surface (16) of the light emitting stack (10) extending between the light emitting surface (12) and the contact surface (11).

**3.** A light emitting device array (1) according to claim 2, wherein the absorbing layer (50) is provided on the light emitting surface (12), wherein the absorbing layer (50) comprises a plurality of openings on the light emitting surface (12), each opening aligned with a second electrical contact (30) such that light from each light emitting device is transmitted through a respective opening.

**4.** A light emitting device array (1) according to any of claims 2 to 3, wherein the absorbing layer (50) is provided in regions of the contact surface (11) between adjacent second electrical contacts (30) of the array of second electrical contacts (30).

**5.** A light emitting device array (1) according to any preceding claim, wherein

the anti-reflection layer (20) comprises a porous semiconducting layer having an areal porosity of at least 30%, and/or
the anti-reflection layer (20) comprises a plurality of porous semiconducting sublayers (22, 24, 26), wherein the areal porosity of at least two of the plurality of porous semiconducting sublayers (22, 24, 26) is different; and/or
a pitch of each second electrical contact (30) in the light emitting device array is no greater than 5 $\mu$m, or 2 $\mu$m.

**6.** A light emitting device array (1) according to any preceding claim, wherein
the first electrical contact layer (40) comprises a transparent conductive oxide provided on the light emitting surface (12), wherein optionally:

the anti-reflection layer (20 is arranged between the first electrical contact layer (40) and the light emitting surface (12), or
the first electrical contact layer (40) is arranged between the anti-reflection layer (20) and the light emitting surface (12).

**7.** A light emitting device array (1) according to any preceding claim, wherein
the anti-reflection layer (20) and the first electrical contact layer (40) are configured to form a graded refractive index (GRIN) structure having both anti-reflection and electrical contact functionality.

**8.** A light emitting device array (1) according to any of claims 1 to 5, wherein the light emitting stack (10) further comprises:

a via semiconducting portion (61) provided in the light emitting stack (10) extending through the active layer (14) between the first semiconducting layer (13) and the contact surface (11), and
the first electrical contact layer (13) is provided on the contact surface (11) in electrical contact with the via semiconducting portion (61).

**9.** A light emitting device array according to any preceding claim, wherein

the first semiconducting layer (13) comprises a n-type doped Group III-nitride; and/or
the second semiconducting layer (15) comprises a p-type doped Group III-nitride; and/or
the active layer (14) comprises multiple quantum well layers comprising Group III-nitrides; and/or
the active layer (14) extends as a continuous layer between at least two adjacent light emitting devices of the light emitting device array (1).

**10.** A method of forming a light emitting device array (1) comprising:

forming a light emitting stack (10) on a substrate surface of a substrate, the light emitting stack (10) having a light emitting surface (12) orientated towards the substrate surface and a contact surface (11) on an opposing side of the light emitting stack (10), forming the light emitting stack (10) comprising forming a plurality of Group III-nitride layers including:

a first semiconducting layer (13) provided towards the substrate surface;
a second semiconducting layer (15) provided towards a contact surface (11) of the light emitting stack (10); and
an active layer (14) provided between the first semiconducting layer (13) and the second semiconducting layer (15), the active layer (14) configured to generate light having a first wavelength;

wherein the light emitting surface (12) and the contact surface (11) of the light emitting stack (10) are formed parallel to each other and aligned with the plurality of Group III-nitride layers;
forming an array of second electrical contacts (30) on the contact surface (11) of the light emitting stack (10), each second electrical contact (30) defining a light emitting device between the first semiconducting layer (13) and the second electrical contact (30), wherein each of the second electrical contacts (30) are spaced apart from the other second electrical contacts (30) to form a two-dimensional array of the light emitting devices;
removing the substrate from the light emitting stack (10);
forming a first electrical contact layer (40) on the light emitting stack (10), the first electrical contact layer (40) configured to be in electrical contact with the first semiconducting layer (13); and
forming an anti-reflection layer (20) on the light emitting surface (12), the anti-reflection layer (20) configured to increase a light extraction efficiency of light generated by the light emitting stack (10).

**11.** A method according to claim 10, further comprising

forming an absorbing layer (50) on at least a portion of the light emitting stack (10), the absorbing configured (50) to absorb light of the first wavelength generated by the active layer (14), and/or
forming the anti-reflection layer (20) comprises:

forming a third semiconducting layer comprising a Group III-nitride and a donor density of at least $1 \times 10^{18}$ $cm^{-3}$ on the light emitting surface (12); and
subjecting the third semiconducting layer to a porosity treatment process to increase an areal porosity of the third semiconducting layer to at least 30%.

**12.** A method according to any of claims 10 to 11, wherein
a pitch of each second electrical contact (30) formed in the light emitting device array is no greater than 5 $\mu$m, or 2 $\mu$m.

**13.** A method according to any of claims 10 to 12, wherein
forming the first electrical contact layer (40) comprises forming a transparent conductive oxide on the light emitting surface (12), wherein optionally:

the anti-reflection layer (20) is formed on the light emitting surface (12), followed by forming the first electrical contact layer (40) on the anti-reflection layer (20), or
the first electrical contact layer (40) is formed on the light emitting surface (12), following by forming the anti-reflection layer (20) on the first electrical contact layer (40).

**14.** A method according to any of claims 10 to 12, wherein
forming the first electrical contact layer (40) comprises:

forming a via semiconducting portion (61) in the light emitting stack (10) extending through the active layer (14)

between the first semiconducting layer (13) and the contact surface (11), and
forming a first electrical contact layer (40) on the contact surface (11) on the via semiconducting portion (61).

**15.** A method according to any of claims 10 to 14, wherein

forming the first semiconducting layer (13) comprises a forming n-type doped Group III-nitride; and/or
forming the second semiconducting layer (15) comprises forming a p-type doped Group III-nitride; and/or
forming the active layer (14) comprises forming multiple quantum well layers comprising Group III-nitrides; and/or
the active layer (14) is formed as a continuous layer extending between at least two adjacent light emitting devices of the light emitting device array.

## Patentansprüche

**1.** Anordnung (1) von lichtemittierenden Vorrichtungen, umfassend:

einen lichtemittierenden Stapel (10) mit einer lichtemittierenden Oberfläche (12) und einer Kontaktoberfläche (11), wobei die lichtemittierende Oberfläche (12) und die Kontaktoberfläche (11) gegenüberliegende Seiten des lichtemittierenden Stapels (10) definieren,
wobei der lichtemittierende Stapel (10) eine Mehrzahl von Gruppe-III-Nitrid-Schichten umfasst, darunter eine erste Halbleiterschicht (13), die in Richtung der lichtemittierenden Oberfläche (12) des lichtemittierenden Stapels (10) vorgesehen ist, eine zweite Halbleiterschicht (15), die in Richtung der Kontaktfläche (11) vorgesehen ist, und eine aktive Schicht (14), die zwischen der ersten Halbleiterschicht (13) und der zweiten Halbleiterschicht (15) angeordnet ist, wobei die aktive Schicht (14) konfiguriert ist, um Licht mit einer ersten Wellenlänge zu erzeugen,
wobei die lichtemittierende Oberfläche (12) und die Kontaktoberfläche (11) parallel zueinander sind und mit der Mehrzahl der Gruppe-III-Nitrid-Schichten fluchten;
eine erste elektrische Kontaktschicht (40) auf dem lichtemittierenden Stapel (10) vorgesehen und konfiguriert ist, um in elektrischem Kontakt mit der ersten Halbleiterschicht (13) zu sein;
eine Anordnung von zweiten elektrischen Kontakten (30) auf der Kontaktfläche (11) des lichtemittierenden Stapels (10) vorgesehen ist, wobei jeder zweite elektrische Kontakt (30) eine lichtemittierende Vorrichtung zwischen der ersten Halbleiterschicht (13) und dem zweiten elektrischen Kontakt (15) definiert,
wobei jeder der zweiten elektrischen Kontakte (30) von den anderen zweiten elektrischen Kontakten (30) beabstandet ist, um eine zweidimensionale Anordnung der lichtemittierenden Vorrichtungen zu bilden;
**dadurch gekennzeichnet, dass** sie ferner:
eine Antireflexionsschicht (20) umfasst, die auf der lichtemittierenden Oberfläche (12) vorgesehen ist, wobei die Antireflexionsschicht (20) konfiguriert ist, um eine Lichtauskopplungseffizienz von durch den lichtemittierenden Stapel (10) erzeugtem Licht zu erhöhen.

**2.** Anordnung (1) von lichtemittierenden Vorrichtungen nach Anspruch 1, die ferner eine Absorptionsschicht (50) umfasst, die konfiguriert ist, um von der aktiven Schicht (14) erzeugtes Licht der ersten Wellenlänge zu absorbieren; wobei die Absorptionsschicht (50) auf mindestens einem Teil des lichtemittierenden Stapels (10) vorgesehen ist, wobei optional
die Absorptionsschicht (50) auf mindestens einer Seitenwandfläche (16) des lichtemittierenden Stapels (10) vorgesehen ist, die sich zwischen der lichtemittierenden Fläche (12) und der Kontaktfläche (11) erstreckt.

**3.** Anordnung (1) von lichtemittierenden Vorrichtungen nach Anspruch 2, bei der die Absorptionsschicht (50) auf der lichtemittierenden Oberfläche (12) vorgesehen ist, wobei die Absorptionsschicht (50) eine Mehrzahl von Öffnungen auf der lichtemittierenden Oberfläche (12) aufweist, wobei jede Öffnung mit einem zweiten elektrischen Kontakt (30) derart fluchtet, dass Licht von jeder lichtemittierenden Vorrichtung durch eine entsprechende Öffnung durchgelassen wird.

**4.** Anordnung (1) von lichtemittierenden Vorrichtungen nach einem der Ansprüche 2 bis 3, bei der die Absorptionsschicht (50) in Bereichen der Kontaktfläche (11) zwischen benachbarten zweiten elektrischen Kontakten (30) der Anordnung von zweiten elektrischen Kontakten (30) vorgesehen ist.

**5.** Anordnung (1) von lichtemittierenden Vorrichtungen nach einem der vorhergehenden Ansprüche, bei der die Antireflexionsschicht (20) eine poröse Halbleiterschicht mit einer Flächenporosität von mindestens 30 % umfasst, und/oder

die Antireflexionsschicht (20) eine Mehrzahl von porösen Halbleiterteilschichten (22, 24, 26) umfasst, wobei die Flächenporosität von mindestens zwei der Mehrzahl von porösen Halbleiterteilschichten (22, 24, 26) unterschiedlich ist; und/oder
ein Abstand jedes zweiten elektrischen Kontakts (30) in der Anordnung von lichtemittierenden Vorrichtungen nicht größer als 5 µm oder 2 µm ist.

**6.** Anordnung (1) von lichtemittierenden Vorrichtungen nach einem der vorhergehenden Ansprüche, bei der die erste elektrische Kontaktschicht (40) ein transparentes leitfähiges Oxid umfasst, das auf der lichtemittierenden Oberfläche (12) vorgesehen ist, wobei optional:

die Antireflexionsschicht (20) zwischen der ersten elektrischen Kontaktschicht (40) und der Licht emittierenden Oberfläche (12) angeordnet ist, oder
die erste elektrische Kontaktschicht (40) zwischen der Antireflexionsschicht (20) und der lichtemittierenden Oberfläche (12) angeordnet ist.

**7.** Anordnung (1) von lichtemittierenden Vorrichtungen nach einem der vorhergehenden Ansprüche, bei der die Antireflexionsschicht (20) und die erste elektrische Kontaktschicht (40) konfiguriert sind, um eine Struktur mit abgestuftem Brechungsindex (graded refractive index, GRIN) zu bilden, die sowohl Antireflexions- als auch elektrische Kontaktfunktionalität aufweist.

**8.** Anordnung (1) von lichtemittierenden Vorrichtungen nach einem der Ansprüche 1 bis 5, bei der der lichtemittierende Stapel (10) ferner einen Durchgangs-Halbleiterabschnitt (61) umfasst, der in dem lichtemittierenden Stapel (10) vorgesehen ist und sich durch die aktive Schicht (14) zwischen der ersten halbleitenden Schicht (13) und der Kontaktfläche (11) erstreckt, und
die erste elektrische Kontaktschicht (13) auf der Kontaktfläche (11) in elektrischem Kontakt mit dem Durchgangs-Halbleiterabschnitt (61) vorgesehen ist.

**9.** Anordnung von lichtemittierenden Vorrichtungen nach einem der vorhergehenden Ansprüche, bei der

die erste halbleitende Schicht (13) ein n-dotiertes Gruppe-III-Nitrid umfasst; und/oder
die zweite halbleitende Schicht (15) ein p-dotiertes Gruppe-III-Nitrid umfasst; und/oder
die aktive Schicht (14) mehrere Quantentopfschichten umfasst, die Gruppe-III-Nitride umfassen; und/oder
die aktive Schicht (14) sich als durchgehende Schicht zwischen mindestens zwei benachbarten lichtemittierenden Vorrichtungen der Anordnung von lichtemittierenden Vorrichtungen (1) erstreckt.

**10.** Verfahren zum Bilden einer Anordnung (1) von lichtemittierenden Vorrichtungen, umfassend:

Bilden eines lichtemittierenden Stapels (10) auf einer Substratoberfläche eines Substrats, wobei der lichtemittierende Stapel (10) eine der Substratoberfläche zugewandte lichtemittierende Oberfläche (12) und eine Kontaktoberfläche (11) auf einer gegenüberliegenden Seite des lichtemittierenden Stapels (10) aufweist, wobei das Bilden des lichtemittierenden Stapels (10) das Bilden einer Mehrzahl von Schichten aus Gruppe-III-Nitrid umfasst, darunter:

eine erste Halbleiterschicht (13), die auf der Substratoberfläche vorgesehen ist;
eine zweite Halbleiterschicht (15), die in Richtung einer Kontaktfläche (11) des lichtemittierenden Stapels (10) vorgesehen ist; und
eine aktive Schicht (14), die zwischen der ersten Halbleiterschicht (13) und der zweiten Halbleiterschicht (15) vorgesehen ist, wobei die aktive Schicht (14) konfiguriert ist, um Licht mit einer ersten Wellenlänge zu erzeugen;

wobei die lichtemittierende Oberfläche (12) und die Kontaktoberfläche (11) des lichtemittierenden Stapels (10) parallel zueinander ausgebildet sind und mit der Mehrzahl von Gruppe-III-Nitrid-Schichten fluchten;
Bilden einer Anordnung von zweiten elektrischen Kontakten (30) auf der Kontaktfläche (11) des lichtemittierenden Stapels (10), wobei jeder zweite elektrische Kontakt (30) eine lichtemittierende Vorrichtung zwischen der ersten halbleitenden Schicht (13) und dem zweiten elektrischen Kontakt (30) definiert, wobei jeder der zweiten elektrischen Kontakte (30) von den anderen zweiten elektrischen Kontakten (30) beabstandet ist, um eine zweidimensionale Anordnung der lichtemittierenden Vorrichtungen zu bilden;
Entfernen des Substrats von dem lichtemittierenden Stapel (10);
Bilden einer ersten elektrischen Kontaktschicht (40) auf dem lichtemittierenden Stapel (10), wobei die erste elektrische Kontaktschicht (40) konfiguriert ist, um in elektrischem Kontakt mit der ersten halbleitenden Schicht (13) zu sein; und
Bilden einer Antireflexionsschicht (20) auf der lichtemittierenden Oberfläche (12), wobei die Antireflexionsschicht (20) konfiguriert ist, um eine Lichtauskopplungseffizienz von durch den lichtemittierenden Stapel (10) erzeugtem Licht zu erhöhen.

**11.** Verfahren nach Anspruch 10, ferner umfassend

Bilden einer Absorptionsschicht (50) auf mindestens einem Teil des lichtemittierenden Stapels (10), wobei die Absorptionsschicht (50) konfiguriert ist, um von der aktiven Schicht (14) erzeugtes Licht der ersten Wellenlänge zu absorbieren, und/oder
bei dem das Bilden der Antireflexionsschicht (20) umfasst:

Bilden einer dritten Halbleiterschicht, die ein Gruppe-III-Nitrid und eine Donatordichte von mindestens $1\times 10^{18}$ $cm^{-3}$ umfasst, auf der lichtemittierenden Oberfläche (12); und
Unterziehen der dritten Halbleiterschicht einem Porositätsbehandlungsverfahren, um die Flächenporosität der dritten Halbleiterschicht auf mindestens 30% zu erhöhen.

**12.** Verfahren nach einem der Ansprüche 10 bis 11, bei dem
ein Abstand jedes zweiten elektrischen Kontakts (30), der in der Anordnung der lichtemittierenden Vorrichtung ausgebildet ist, nicht größer als 5 μm oder 2 μm ist.

**13.** Verfahren nach einem der Ansprüche 10 bis 12, bei dem das Bilden der ersten elektrischen Kontaktschicht (40) das Bilden eines transparenten leitfähigen Oxids auf der lichtemittierenden Oberfläche (12) umfasst, wobei optional:

die Antireflexionsschicht (20) auf der lichtemittierenden Oberfläche (12) gebildet wird, gefolgt vom Bilden der ersten elektrischen Kontaktschicht (40) auf der Antireflexionsschicht (20), oder
die erste elektrische Kontaktschicht (40) auf der lichtemittierenden Oberfläche (12) gebildet wird, gefolgt vom Bilden der Antireflexionsschicht (20) auf der ersten elektrischen Kontaktschicht (40).

**14.** Verfahren nach einem der Ansprüche 10 bis 12, bei dem das Bilden der ersten elektrischen Kontaktschicht (40) umfasst:

Bilden eines Halbleiter-Durchgangsabschnitts (61) in dem lichtemittierenden Stapel (10), der sich durch die aktive Schicht (14) zwischen der ersten Halbleiterschicht (13) und der Kontaktfläche (11) erstreckt, und
Bilden einer ersten elektrischen Kontaktschicht (40) auf der Kontaktfläche (11) auf dem Durchgangs-Halbleiterabschnitt (61).

**15.** Verfahren nach einem der Ansprüche 10 bis 14, bei dem das Bilden der ersten halbleitenden Schicht (13) ein Bilden von n-dotiertem Gruppe-III-Nitrid umfasst; und/oder

das Bilden der zweiten halbleitenden Schicht (15) das Bilden von p-dotiertem Gruppe-III-Nitrid umfasst; und/oder
das Bilden der aktiven Schicht (14) das Bilden mehrerer Quantentopfschichten umfasst, die Gruppe-III-Nitride umfassen; und/ oder
die aktive Schicht (14) als eine kontinuierliche Schicht gebildet wird, die sich zwischen mindestens zwei benachbarten lichtemittierenden Vorrichtungen der Anordnung von lichtemittierenden Vorrichtungen erstreckt.

## Revendications

**1.** Réseau de dispositifs électroluminescents (1) comprenant :

un empilement électroluminescent (10) présentant une surface électroluminescente (12) et une surface de contact (11), la surface électroluminescente (12) et la surface de contact (11) définissant les côtés opposés de l’empilement électroluminescent (10),

l'empilement électroluminescent (10) comprenant une pluralité de couches de nitrure de groupe III comportant une première couche semi-conductrice (13) prévue en direction de la surface électroluminescente (12) de l'empilement électroluminescent (10), une deuxième couche semi-conductrice (15) prévue en direction de la surface de contact (11), et une couche active (14) agencée entre la première couche semi-conductrice (13) et la deuxième couche semi-conductrice (15), la couche active (14) étant configurée pour générer de la lumière présentant une première longueur d'onde,

dans lequel la surface électroluminescente (12) et la surface de contact (11) sont parallèles l'une à l'autre et alignées avec la pluralité de couches de nitrure de groupe III ;

une première couche de contact électrique (40) prévue sur l'empilement électroluminescent (10) et configurée pour être en contact électrique avec la première couche semi-conductrice (13) ;

un réseau de deuxièmes contacts électriques (30) prévus sur la surface de contact (11) de l'empilement électroluminescent (10), chaque deuxième contact électrique (30) définissant un dispositif électroluminescent entre la première couche semi-conductrice (13) et le deuxième contact électrique (15), dans lequel chacun des deuxièmes contacts électriques (30) est espacé des autres deuxièmes contacts électriques (30) pour former un réseau bidimensionnel des dispositifs électroluminescents ;

**caractérisé en ce qu'**il comprend en outre :

une couche antireflet (20) prévue sur la surface électroluminescente (12), la couche antireflet (20) étant configurée pour augmenter une efficacité d'extraction de lumière de la lumière générée par l'empilement électroluminescent (10).

**2.** Réseau de dispositifs électroluminescents (1) selon la revendication 1, comprenant en outre

une couche absorbante (50) configurée pour absorber la lumière de la première longueur d'onde générée par la couche active (14) ; la couche absorbante (50) étant prévue sur au moins une partie de l'empilement électroluminescent (10), dans lequel éventuellement

la couche absorbante (50) est prévue sur au moins une surface de paroi latérale (16) de l'empilement électroluminescent (10) s'étendant entre la surface électroluminescente (12) et la surface de contact (11).

**3.** Réseau de dispositifs électroluminescents (1) selon la revendication 2, dans lequel la couche absorbante (50) est prévue sur la surface électroluminescente (12), dans lequel la couche absorbante (50) comprend une pluralité d'ouvertures sur la surface électroluminescente (12), chaque ouverture étant alignée avec un deuxième contact électrique (30) de telle sorte que la lumière provenant de chaque dispositif électroluminescent est transmise à travers une ouverture respective.

**4.** Réseau de dispositifs électroluminescents (1) selon l'une quelconque des revendications 2 à 3, dans lequel la couche absorbante (50) est prévue dans des zones de la surface de contact (11) entre des deuxièmes contacts électriques (30) adjacents du réseau de deuxièmes contacts électriques (30).

**5.** Réseau de dispositifs électroluminescents (1) selon une quelconque revendication précédente, dans lequel

la couche antireflet (20) comprend une couche semi-conductrice poreuse présentant une porosité surfacique d'au moins 30 %, et/ou

la couche antireflet (20) comprend une pluralité de sous-couches semi-conductrices poreuses (22, 24, 26), dans lequel la porosité surfacique d'au moins deux de la pluralité de sous-couches semi-conductrices poreuses (22, 24, 26) est différente ; et/ou

un pas de chaque deuxième contact électrique (30) dans le réseau de dispositifs électroluminescents n'est pas supérieur à 5 $\mu$m, ou 2 $\mu$m.

**6.** Réseau de dispositifs électroluminescents (1) selon une quelconque revendication précédente, dans lequel la première couche de contact électrique (40) comprend un oxyde conducteur transparent prévu sur la surface électroluminescente (12), dans lequel éventuellement :

la couche antireflet (20) est agencée entre la première couche de contact électrique (40) et la surface électroluminescente (12), ou

la première couche de contact électrique (40) est agencée entre la couche antireflet (20) et la surface électroluminescente (12).

**7.** Réseau de dispositifs électroluminescents (1) selon une quelconque revendication précédente, dans lequel

la couche antireflet (20) et la première couche de contact électrique (40) sont configurées pour former une structure à gradient d'indice de réfraction (GRIN) présentant à la fois une fonctionnalité antireflet et de contact électrique.

**8.** Réseau de dispositifs électroluminescents (1) selon l'une quelconque des revendications 1 à 5, dans lequel l'empilement électroluminescent (10) comprend en outre :

une partie semi-conductrice de trou d'interconnexion (61) prévue dans l'empilement électroluminescent (10) s'étendant à travers la couche active (14) entre la première couche semi-conductrice (13) et la surface de contact (11), et
la première couche de contact électrique (13) est prévue sur la surface de contact (11) en contact électrique avec la partie semi-conductrice de trou d'interconnexion (61).

**9.** Réseau de dispositifs électroluminescents selon une quelconque revendication précédente, dans lequel

la première couche semi-conductrice (13) comprend un nitrure de groupe III dopé de type n ; et/ou
la deuxième couche semi-conductrice (15) comprend un nitrure de groupe III dopé de type p ; et/ou
la couche active (14) comprend de multiples couches de puits quantique comprenant des nitrures de groupe III ; et/ou
la couche active (14) s'étend en tant que couche continue entre au moins deux dispositifs électroluminescents adjacents du réseau de dispositifs électroluminescents (1).

**10.** Procédé de formation d'un réseau de dispositifs électroluminescents (1) comprenant :
la formation d'un empilement électroluminescent (10) sur une surface de substrat d'un substrat, l'empilement électroluminescent (10) présentant une surface électroluminescente (12) orientée en direction de la surface de substrat et une surface de contact (11) sur un côté opposé de l'empilement électroluminescent (10), la formation de l'empilement électroluminescent (10) comprenant la formation d'une pluralité de couches de nitrure de groupe III comportant :

une première couche semi-conductrice (13) prévue en direction de la surface de substrat ;
une deuxième couche semi-conductrice (15) prévue en direction d'une surface de contact (11) de l'empilement électroluminescent (10) ; et
une couche active (14) prévue entre la première couche semi-conductrice (13) et la deuxième couche semi-conductrice (15), la couche active (14) étant configurée pour générer de la lumière présentant une première longueur d'onde ;
dans lequel la surface électroluminescente (12) et la surface de contact (11) de l'empilement électroluminescent (10) sont formées parallèlement l'une à l'autre et alignées avec la pluralité de couches de nitrure de groupe III ;
la formation d'un réseau de deuxièmes contacts électriques (30) sur la surface de contact (11) de l'empilement électroluminescent (10), chaque deuxième contact électrique (30) définissant un dispositif électroluminescent entre la première couche semi-conductrice (13) et le deuxième contact électrique (30), dans lequel chacun des deuxièmes contacts électriques (30) sont espacés des autres deuxièmes contacts électriques (30) pour former un réseau bidimensionnel des dispositifs électroluminescents ;
le retrait du substrat de l'empilement électroluminescent (10) ;
la formation d'une première couche de contact électrique (40) sur l'empilement électroluminescent (10), la première couche de contact électrique (40) étant configurée pour être en contact électrique avec la première couche semi-conductrice (13) ; et
la formation d'une couche antireflet (20) sur la surface électroluminescente (12), la couche antireflet (20) étant configurée pour augmenter une efficacité d'extraction de lumière de la lumière générée par l'empilement électroluminescent (10).

**11.** Procédé selon la revendication 10, comprenant en outre

la formation d'une couche absorbante (50) sur au moins une partie de l'empilement électroluminescent (10), l'absorbante étant configurée (50) pour absorber la lumière de la première longueur d'onde générée par la couche active (14), et/ou
la formation de la couche antireflet (20) comprend :

la formation d'une troisième couche semi-conductrice comprenant un nitrure de groupe III et une densité donneuse d'au moins $1 \times 10^{18}$ $cm^{-3}$ sur la surface électroluminescente (12) ; et
la soumission de la troisième couche semi-conductrice à un processus de traitement de porosité pour augmenter une porosité surfacique de la troisième couche semi-conductrice à au moins 30 %.

**12.** Procédé selon l'une quelconque des revendications 10 à 11, dans lequel
un pas de chaque deuxième contact électrique (30) formé dans le réseau de dispositifs électroluminescents n'est pas supérieur à 5 μm, ou 2 um.

**13.** Procédé selon l'une quelconque des revendications 10 à 12, dans lequel
la formation de la première couche de contact électrique (40) comprend la formation d'un oxyde conducteur transparent sur la surface électroluminescente (12), dans lequel éventuellement :

la couche antireflet (20) est formée sur la surface électroluminescente (12), suivie par la formation de la première couche de contact électrique (40) sur la couche antireflet (20), ou
la première couche de contact électrique (40) est formée sur la surface électroluminescente (12), suivie par la formation de la couche antireflet (20) sur la première couche de contact électrique (40).

**14.** Procédé selon l'une quelconque des revendications 10 à 12, dans lequel
la formation de la première couche de contact électrique (40) comprend :

la formation d'une partie semi-conductrice de trou d'interconnexion (61) dans l'empilement électroluminescent (10) s'étendant à travers la couche active (14) entre la première couche semi-conductrice (13) et la surface de contact (11), et
la formation d'une première couche de contact électrique (40) sur la surface de contact (11) sur la partie semi-conductrice de trou d'interconnexion (61).

**15.** Procédé selon l'une quelconque des revendications 10 à 14, dans lequel

la formation de la première couche semi-conductrice (13) comprend une formation de nitrure de groupe III dopé de type n ; et/ou
la formation de la deuxième couche semi-conductrice (15) comprend la formation d'un nitrure de groupe III dopé de type p ; et/ou
la formation de la couche active (14) comprend la formation de multiples couches de puits quantique comprenant des nitrures de groupe III ; et/ou
la couche active (14) est formée en tant que couche continue s'étendant entre au moins deux dispositifs électroluminescents adjacents du réseau de dispositifs électroluminescents.

50
51
13
16
14
15
52
11
12
1
40
10
20
30
30
30

FIG. 1

50
10
11
1
40
20
14
13
15
30
30
Pitch
θ2
θc
θ1
n Sinθ1 = Sinθ2
d/n
d
FIG. 2

Absorptance
0.705
0.700
0.695
0.690
0.685
0.680
0.675
0.670
0.665
0.660
0.655
400
425
450
475
500
525
550
575
600
625
650
675
700
Wavelength (nm)

FIG. 3a

Ti

GaN

FIG. 3b

Absorptance
0.70
0.68
0.66
0.64
0.62
0.60
0.58
0.56
0.54
400
425
450
475
500
525
550
575
600
625
650
675
700
Wavelength (nm)

*FIG. 4a*

Ni

GaN

*FIG. 4b*

12
10
13
N-GaN
TIR
15
P-GaN
14

FIG. 5a

1.2
1
0.8
0.6
0.4
0.2
0
Reflectance
400
450
500
550
600
650
700
Wavelength (nm)
Normal incidence
20 degree
24 degree

FIG. 5b

20
$\frac{\lambda_0}{4 n_p}$
N-GaN (70% porosity)
10
12
13
N-GaN
14
15
P-GaN

FIG. 6a

1.2
1
0.8
0.6
0.4
0.2
0
Reflectance
400
450
500
550
600
650
700
Wavelength (nm)
Normal incidence
20 degree
24 degree

FIG. 6b

n0
t1
t2
n1
n2
n3
12
N-GaN
P-GaN

$$r_1 = \frac{n_0 - n_1}{n_0 + n_1} \qquad r_2 = \frac{n_1 - n_2}{n_1 + n_2} \qquad r_3 = \frac{n_2 - n_3}{n_2 + n_3}$$

$$\theta_1 = \frac{2\pi n_1 t_1}{\lambda} \qquad \theta_2 = \frac{2\pi n_2 t_2}{\lambda}$$

$$R = |r^2| = \frac{r_1^2 + r_2^2 + r_3^2 + r_1^2 r_2^2 r_3^2 + 2r_1 r_2 (1 + r_3^2) \cos 2\theta_1 + 2r_2 r_3 (1 + r_1^2) \cos 2\theta_2 + 2r_1 r_3 \cos 2(\theta_1 + \theta_2) + 2r_1 r_2^2 r_3 \cos 2(\theta_1 - \theta_2)}{1 + r_1^2 r_2^2 + r_1^2 r_3^2 + r_2^2 r_3^2 + 2r_1 r_2 (1 + r_3^2) \cos 2\theta_1 + 2r_2 r_3 (1 + r_1^2) \cos 2\theta + 2r_1 r_3 \cos 2(\theta_1 + \theta_2) + 2r_1 r_2^2 r_3 \cos 2(\theta_1 - \theta_2)}$$

*FIG. 7*

210nm
ITO
40
100nm
N-GaN (70% porosity)
20
10
12
13
N-GaN
14
15
P-GaN

*FIG. 8*

Reflectance
0.30
0.25
0.20
0.15
0.10
0.05
0.00
400
425
450
475
500
525
550
575
600
625
650
670
700
Wavelength (nm)

*FIG. 9*

65nm
SiO2
20
250nm
ITO
40
10
12
13
N-GaN
14
15
P-GaN

FIG. 10

0.060
0.050
0.040
0.030
0.020
0.010
0.000
Reflectance
400
425
450
475
500
525
550
575
600
625
650
670
700
Wavelength (nm)

FIG. 11

230nm
ITO
60nm
N-GaN (70% porosity)
26
50nm
N-GaN (40% porosity)
24
50nm
N-GaN (20% porosity)
22
10
13
N-GaN
14
15
P-GaN

*FIG. 12*

0.25
0.20
0.15
0.10
0.05
0.00
Reflectance
400
425
450
475
500
525
550
575
600
625
650
670
700
Wavelength (nm)

*FIG. 13*

28
GRIN ITO
40
20
12
10
N-GaN
13
14
15
P-GaN

FIG. 14

2
50
51
13
16
10
14
15
52
12
53
30
40
20
53
30
30
53
FIG. 15

3
50
10
53
12
54
53
30
20
54
53
30
40
54
53
30
54
53
FIG. 16

10
11
pGAN
15
14
MQW
nGaN
13
12

FIG. 17a

62
62
SiO2
pGAN
15
14
MQW
nGaN
13

FIG. 17b

62
61
61
SiO2
pGAN
15
14
MQW
nGaN
13

FIG. 17c

30
P-contact
pGAN
MQW
nGaN
14
15
13

FIG. 17d

41
63
30
63
41
P-contact
pGAN
MQW
nGaN
61
61
13

FIG. 17e

42
30
30
30

FIG. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2016365383 A
- EP 3624198 A
- US 20170237234 A


### Non-patent literature cited in the description


- **JONG KYU KIM.** Light-Extraction Enhancement of GaInN Light Emitting Diodes by Graded-Refractive-Index Indium Tin Oxide Anti-Reflection Contact. *Advanced Materials,* vol. 0000 (00), 1-5
- **XIULING LI ; YOUNG WOON-KIM et al.** In-plane bandgap control in porous GaN through electroless wet chemical etching. *Applied Physics Letters,* 11 February 2002, vol. 8 (6
- *ACS Applied Nano Materials,* 2020, vol. 3, 399-402